(19) **Europäisches Patentamt European Patent Office Office européen des brevets**

(11) **EP 3 360 855 B1**

(12) **FASCICULE DE BREVET EUROPEEN**

(45) Date de publication et mention de la délivrance du brevet:
**18.03.2020 Bulletin 2020/12**

(51) Int Cl.:
**C04B 35/01** *(2006.01)*  **C25B 11/04** *(2006.01)*

(21) Numéro de dépôt: **17203129.6**

(22) Date de dépôt: **17.05.2007**

(54) **PROCÉDÉ DE PRÉPARATION DE CÉRAMIQUES, CÉRAMIQUES AINSI OBTENUES ET LEURS UTILISATIONS NOTAMMENT COMME CIBLE POUR PULVÉRISATION CATHODIQUE**

**HERSTELLUNGSVERFAHREN VON KERAMIKEN, SO ERHALTENE KERAMIKEN UND IHRE VERWENDUNG ALS ZIELSCHEIBE FÜR KATHODENZERSTÄUBUNG**

**METHOD FOR PREPARING CERAMICS, CERAMICS THUS OBTAINED AND USES THEREOF, PARTICULARLY AS A TARGET FOR CATHODE SPUTTERING**

(84) Etats contractants désignés:
**AT BE BG CH CY CZ DE DK EE ES FI FR GB GR HU IE IS IT LI LT LU LV MC MT NL PL PT RO SE SI SK TR**

(30) Priorité: **18.05.2006 CA 2547091**
**24.07.2006 CA 2553146**

(43) Date de publication de la demande:
**15.08.2018 Bulletin 2018/33**

(62) Numéro(s) de document de la (des) demande(s) initiale(s) en application de l'article 76 CBE:
**07719803.4 / 2 029 500**

(72) Inventeurs:
- **CAMPET, Guy**
**33610 CANEJAN (FR)**
- **SAADEDDIN, Iyad**
**33170 GRADIGNAN (FR)**
- **ZAGHIB, Karim**
**Longueuil, Québec J4M 2M7 (CA)**

(74) Mandataire: **Lavoix**
**Bayerstrasse 83**
**80335 München (DE)**

(56) Documents cités:
**US-A- 5 071 800**

(73) Titulaires:
- **HYDRO-QUEBEC**
**Montréal, Québec H2Z 1A4 (CA)**
- **CENTRE NATIONAL DE LA RECHERCHE SCIENTIFIQUE**
**75016 Paris (FR)**

**EP 3 360 855 B1**

**Description**

**DOMAINE DE L'INVENTION**

L'invention est relative à un procédé de préparation de céramiques, notamment de céramiques à haute densité.

L'invention réside aussi dans les céramiques et éléments cibles obtenus par mise en œuvre des procédés de l'invention. Ces céramiques et éléments cibles se caractérisent par des propriétés mécaniques remarquables, notamment par une forte densité apparente proche de la densité théorique.

De plus, la présente invention concerne les utilisations de ces céramiques et éléments de cible, notamment la mise en œuvre des procédés permettant la réalisation de films en couche mince par pulvérisation cathodique à partir des cibles, et d'électrodes pour dispositifs électrochimiques (microgénérateurs, dispositifs électrochromes, capteurs de gaz, etc.).

Les films et électrodes ainsi obtenues, notamment ceux obtenus en couches minces qui présentent des propriétés particulièrement intéressantes, constituent également un aspect de la présente invention.

**ÉTAT DE L'ART**

Au cours des dernières années, le revêtement de divers matériaux, par des couches minces à propriétés particulières, a fait l'objet d'un développement considérable. A titre d'exemple d'utilisation de cette technologie, on mentionne traditionnellement le dépôt de matériaux ultradurs sur des pièces mécaniques, d'électrodes transparentes et à conductivité de type métallique pour dispositifs optoélectroniques, d'électrodes pour dispositifs électrochromes, d'électrodes pour microbatteries, le dépôt de couches anticorrosives sur les métaux et de couches antireflet sur les verres d'optique.

Les nombreuses méthodes utilisables pour la réalisation de telles couches diffèrent sensiblement en fonction de l'identité chimique du ou des composés générateurs de la couche de revêtement.

Les méthodes de dépôt chimique en phase vapeur, assisté ou non par plasma, sont adaptées dans le contexte de composés générateurs de types gazeux.

Dans le cas des composés générateurs liquides ou susceptibles d'être mis en solution, on utilise généralement la méthode qui consiste à déposer une couche d'un métal, ou bien des méthodes du type dépôt à la tournette ou de dépôt par pulvérisation d'un brouillard chaud.

Lorsque la source génératrice du revêtement est un matériau de type solide, on utilise avantageusement une pulvérisation cathodique de type RF ou DC telle que décrite notamment dans "http://pagesperso.laposte.net/librebel/download3/ pulve.pdf" et dans Study of Indium Tin Oxide (ITO) for Novel Optoelectronic Devices by Shabbir A. Bashar B.Eng. Submitted in accordance with the requirement for the Degree of Doctor of Philosophy KING'S COLLEGE LONDON, University of London, Department of Electronic Engineering 1998.

Le matériau solide générateur du revêtement, habituellement appelé "matériau cible" ou "cible", peut être constitué par un métal, par un alliage métallique ou bien par un composé chimique inorganique à point de fusion particulièrement élevé. Dans ce contexte, on bombarde une céramique constituée d'un oxyde réfractaire à l'aide d'une source d'ions ayant une énergie suffisante pour arracher des particules du matériau cible. Les particules ainsi arrachées se déposent (par transfert de matière) sur l'objet à revêtir.

La distance entre l'émetteur de particules, c'est-à-dire la cible, et le récepteur, c'est-à-dire le substrat sur lequel sont déposées les particules ayant l'énergie cinétique requise pour donner le film, varie généralement entre environ 4 et 15 cm. À condition que la surface du matériau cible à déposer sur l'objet soit de taille suffisante, on obtient alors une homogénéité et une vitesse de croissance adéquate pour le dépôt formé à partir des particules arrachées au matériau cible.

La fabrication de cibles de grande surface à partir de métaux ou d'alliages métalliques est relativement facile à réaliser en passant par l'étape intermédiaire de préparation d'une céramique. Dans le cas de préparation de telles cibles à partir de composés chimiques inorganiques à haut point de fusion, l'opération s'avère délicate en raison des difficultés qu'il y a à réaliser au préalable une céramique ayant les caractéristiques requises. Pour chaque nouveau matériau inorganique utilisé dans le but de produire une céramique, il est nécessaire de mettre au point les paramètres du procédé. Il s'agit d'une opération qui peut s'avérer aléatoire, longue et complexe et qui résulte dans des coûts d'exploitation élevés, en particulier lorsqu'on utilise une technique impliquant des pressions élevées. De telles méthodes sont trop délicates pour être mises en production par un simple opérateur, l'implication d'un spécialiste s'avère indispensable.

Traditionnellement deux techniques de frittage sont principalement employées pour la fabrication de céramiques (cibles) destinées à être utilisées dans le cadre d'une pulvérisation cathodique.

Le premier procédé est qualifié de frittage "naturel" à partir d'une cible qui est préparée comme suit :

- **(i)** *étape de compactage* : la poudre du matériau inorganique est préalablement compactée à température ambiante dans un moule approprié, supportant des pressions élevées, de l'ordre de 1 tonne/cm². Des additifs, tel que le camphre, peuvent être ajoutés pour faciliter le compactage et, de ce fait, le démoulage de la poudre ainsi compactée avant son frittage en température; et

- **(ii)** *étape de frittage* : pour des éléments compactés de grande surface ($\geq$ 100 cm²), on se heurte cependant à des difficultés techniques (outre "l'encombrement" du moule qui est également onéreux) pour enlever l'élément compacté du moule sans le détériorer et l'amener sans dommage dans le four pour y être fritté pour donner la céramique finale.

Ce procédé qui comprend ainsi deux étapes (i) et (ii) s'avère délicat à mettre en œuvre, particulièrement au niveau de la deuxième étape et pour les cibles de grande surface.

Pour ces raisons, les industriels font généralement appel à un deuxième procédé, communément appelé de pressage à chaud (HP = hot pressing). Il s'agit d'un compactage à chaud de la poudre du matériau inorganique dans un moule approprié, inerte chimiquement, et supportant des pressions et températures élevées.

Bien que cette deuxième méthode permette d'obtenir des céramiques de bonne qualité (homogènes, denses) en une seule étape, ce procédé de fabrication présente l'inconvénient de nécessiter la mise en œuvre d'un équipement lourd et très onéreux, notamment pour des cibles de grande surface.

Le procédé d'utilisation d'une céramique comme cible pour pulvérisation cathodique est décrit dans Study of Indium Tin Oxide (ITO) for Novel Optoelectronic Devices by Shabbir A. Bashar B.Eng. Submitted, in accordance with the requirement for the Degree of Doctor of Philosophy KING'S COLLEGE LONDON, University of London, Department of Electronic Engineering, 1998.

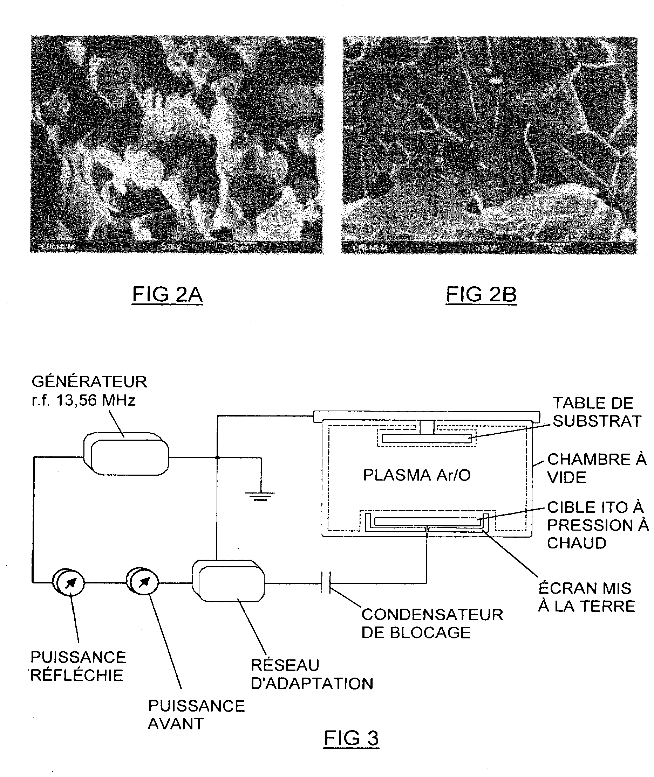

La pulvérisation cathodique est un phénomène d'éjection des particules à partir de la surface d'un matériau, lorsque celui-ci est bombardé par un flux de particules énergétiques. Le schéma traditionnel de pulvérisation cathodique diode est présenté dans la Figure 3.

Les particules, généralement des ions d'argon Ar⁺ du plasma, sont accélérées dans le champ électrique de la cible, portée à une tension négative par rapport à celle du plasma. Les particules pulvérisées sont en général neutres. Elles sont diffusées dans toute l'enceinte. Un certain nombre d'entre elles sont recueillies sur un support appelé substrat, placé en face de la cible, et sur lequel elles forment une couche mince. Le plasma, appelé aussi la décharge luminescente, est la base de la pulvérisation cathodique.

La publication intitulée Zinc Doping in Cosubstituted $In_{2-2x}Sn_xZn_xO_{3-\delta}$ de A. Ambrosini, dans Chem. Mater. 2002, 14, 58-63, mentionne une solution solide cosubstituée de $In_{2-2x}Sn_xZn_xO_{3-\delta}$ dopé accepteur avec $Zn^{2+}$ pour former $In_{2-x-y}Sn_xZn_xO_{3-\delta}$ (y > x). Un excès de 4 % de $Zn^{2+}$ peut être introduit dans $In_{1,6}Zn_{0,2}O_{3-\delta}$ tout en maintenant la structure bixbyite. La conductivité de type n du matériau dopé décroît avec la substitution par le zinc. $In_{1,6}Sn_{0,2}Zn_{0,2}O_{3-\delta}$ dopé avec du zinc a été recuite sous une forte pression d'oxygène (170 atm) pour éliminer la vacance des anions. Vo" conduisant à une diminution de la concentration du support jusqu'à 2 ordres de magnitude, de $10^{20}$ à $10^{18}$ supports/cm³, la conductivité du matériau recuit décroît. Les mesures de Hall montrent que les supports restent de type n. Les résultats impliquent l'existence de complexes neutres Zn-Vo" qui empêchent le don de trous pour $Zn^{2+}$.

Le procédé décrit dans cette publication est relatif à une méthode de préparation des céramiques qui comporte un premier pressage réalisé à température ambiante, à une pression très élevée de 7-8 MPa par cm². Cette méthode permet d'obtenir des céramiques ayant des densités proches de la densité théorique, mais présente l'inconvénient d'être complexe (au moins deux étapes de pressage) et de nécessiter un apport énergétique très important.

La publication de I. Saadeddin et al., intitulée Simultaneous doping of Zn and Sb in SnO2 ceramics: enhancement of electrical conductivity, dans Solid State Sciences 8 (2006) 7-13 publié le 21 octobre 2005, décrit des céramiques à base de $SnO_2$ dopées avec Sb et/ou Zn et préparées par réaction à l'état solide, à 1300°C. L'effet des dopants sur les propriétés électroniques et sur le frittage ont été étudiées. Alors que des céramiques de $SnO_2$ non dopées présentent des conductivités électriques très basses et de plus faibles densités, les céramiques dopées au Sb montrent des conductivités électriques plus élevées, avec presque aucune densification et avec une perte significative d'antimoine. Au contraire, une forte densification et une faible conductivité sont obtenues pour les céramiques dopées avec Zn. Pour cette raison, les auteurs ont étudié les céramiques $SnO_2$ co-dopées avec Sb et Zn ($SnO_2$:Sb:Zn) pour combiner les avantages des deux dopants. L'analyse par spectroscopie de photoélectrons X a confirmé que le $Sb^{5+}$ est principalement substitué aux sites $Sn^{4+}$ pour les céramiques dopées avec Sb, en accord avec les mesures de Hall. Dans le cas d'échantillons de $SnO_2$ co-dopés avec Sb et Zn, une conductivité électrique et une densité élevées sont observées. En addition, la présence de Zn évite l'évaporation de Sb pendant le frittage.

Le procédé décrit dans cette publication implique nécessairement une étape de pressage avec des pressions de l'ordre de 185 MPa et les pores des céramiques décrites dans cette publication sont d'une taille relativement faible. L'intérêt de ce procédé est limité en raison de sa complexité et des coûts importants d'exploitation qui y sont associés.

La publication intitulée Effect of ZnO addition in $In_2O_3$ ceramics: defect chemistry and sintering behaviour de Dong-Hyuk Park et al., dans Solid State Ionic 172 (2004) 431-434, décrit l'étude des caractéristiques de la solution de $Zn^{2+}$ dans $In_2O_3$ en fonction de la teneur en Zn et de l'atmosphère de frittage. La limite de solubilité de Zn dans $In_2O_3$

est proche de 1 at.% lorsque IZO (indium zinc oxide) est fritté dans une atmosphère d'oxygène. Le frittage dans l'azote diminue la limite de solubilité en-dessous de 1 at.%. Sur la base d'une analyse microstructurale et de caractéristiques électriques, il a été trouvé que Zn forme une solution solide de substitution avec $In_2O_3$ jusqu'à 0,5 at.% puis se transforme en solution interstitielle solide en dessous de 0,5 % lorsque des échantillons sont frittés dans l'oxygène. Au contraire, Zn forme une solution solide interstitielle lorsque les échantillons sont frittés dans l'azote. Il est discuté dans ce document de la chimie par défaut basée sur la structure instable de $In_2O_3$.

Le procédé de préparation de céramique décrit dans cette publication implique que les céramiques obtenues le sont par pressage à 100 MPa. Les céramiques décrites dans cette publication présentent une densité électronique par unité de volume faible, ce qui en limite considérablement l'intérêt.

La demande internationale de la Société Nationale Elf Aquitaine publiée le 24 juin 1993 sous le numéro WO 93/12264 décrit un procédé dans lequel pour former un élément cible, on constitue un système précurseur susceptible de donner naissance au matériau inorganique à une température $\theta$ comprise entre 300°C et 1600°C et inférieur au point de fusion dudit matériau. Le système précurseur renferme un adjuvant inorganique de point de fusion inférieur ou égal à $\theta$. On applique le système précurseur sur un support, à l'exclusion d'une mousse ou feutre métallique. On porte l'élément résultant à la température $\theta$ et on maintient ladite température pendant une durée suffisante pour produire le matériau inorganique, puis on refroidit l'ensemble matériau inorganique /support jusqu'à la température ambiante en évitant toute trempe.

Le procédé décrit dans cette publication se caractérise par le fait que les adjuvants utilisés sont présents à une quantité d'au moins 20 %, et ils ne sont pas utilisés pour créer des lacunes anioniques dans le matériau de base par substitution. Il est précisé dans ce document que l'adjuvant peut être un fondant comme LiF, LiCI; il doit être préférentiellement un carbonate de lithium, de sodium ou de potassium. Dans le cas des carbonates, la densification intervient au cours du dégagement de $CO_2$ lors du chauffage. Par ailleurs, avec ces adjuvants, les céramiques obtenues présentent des densités faibles, de l'ordre de 50 % de la densité théorique.

La publication de N. Ito et al., intituée Electrical and optical properties of amorphous indium zinc oxide films, du 28 septembre 2005, décrit une investigation du contrôle de la valence électronique et des mécanismes de transport électronique de films amorphes d'oxydes de zinc et d'indium (IZO).

$In_2O_3$ dopé à l'étain (Sn) (connu sous ITO) est un OCT (oxyde conducteur transparent) bien connu, témoignant de plus de 50 années de recherches scientifiques intensives et d'applications techniques. Dans un film mince, ITO montre une combinaison remarquable de propriétés optiques et de transport électrique [1-11]: (i) résistivité électrique faible ($\sim 1$-$2 \times 10^{-4}$ $\Omega$.cm) et (ii) transparence optique élevée (> 80 %) dans la partie visible du spectre solaire. Cependant, pour atteindre de telles propriétés, les films doivent être déposés ou recuits post-dépôt à une température égale à ou plus grande que $\sim 200$°C. De nos jours, l'accent est mis sur la préparation de couches de OCT ayant des performances électroniques et optiques élevées à des températures de dépôt faibles ($\leq 80$°C), pour être compatibles avec des technologies émergeantes liées à des composés organiques, telles que les OLED (organic light-emitting diode = diode électroluminescente organique) flexibles, les cellules solaires photovoltaïques à base de polymère, etc., pour lesquelles les substrats plastiques à faible coût sont utilisés. Pour cette raison, les films minces d'oxyde d'indium-zinc (IZO) amorphes déposés à faible température ont été de plus en plus étudiés [12-22]. En plus de la transparence optique élevée dans le visible, ces films IZO amorphes par rayons X ont des résistivités typiquement faibles ($3$-$6 \times 10^{-4}$ $\Omega$.cm), c'est-à-dire plus faibles que celles mesurées pour les homologues ITO amorphes ($7$-$10 \times 010^{-4}$ $\Omega$.cm) [10,18].

Le diagramme de phase binaire $In_2O_3$-ZnO inclut une série de composés IZO homologues ayant la formule chimique $Zn_k In_2 O_{3+k}$ (k = 2-9, 11, 13, 15); ces oxydes montrent des structures ayant des couches hexagonales et pas de structure cubique type bixbyite parce que la teneur en Zn excède la limite de solubilité dans la structure type bixbyite de $In_2O_3$ [15, 23, 24]. La limite de solubilité de ZnO dans $In_2O_3$ a été trouvée par D. H. Park et al. à 1-2 mol. % [24]. Cependant, il s'est avéré que la limite de solubilité de $Zn^{2+}$ dans la céramique $In_2O_3$ augmente jusqu'à 40 mol. % lorsque $In^{3+}$ est co-substitué par $Zn^{2+}$ et $Sn^{4+}$ [25]. Malheureusement, les céramiques rapportées $In_2O_3$ co-substituées par $Zn^{2+}$-$Sn^{4+}$ se sont avérées avoir des densités apparentes faibles ($\leq 60$ % de la densité théorique) et des résistivités plus élevées que leurs homologues ITO [25-27].

Quelques travaux ont été rapportés pour les films OCT déposés par pulvérisation cathodiques utilisant des mélanges de poudres ZnO-$In_2O_3$-$SnO_2$ [28-30] comme cibles. Afin d'approcher la conductivité de ITO, les films sont déposés sur des substrats en verre à des températures $\geq 160$°C; par conséquent, les substrats (en plastique) sensibles à la chaleur ne pouvaient pas être utilisés. De plus, les films à multi-composés $Zn_2In_2O_5$-$ZnSnO_3$ et à composé ternaire $Zn_2In_2O_5$ ont été préparés en utilisant de telles cibles à base de mélange de poudre.

Le document US 5071800 décrit une poudre d'oxyde d'indium ou une poudre d'oxyde d'indium / oxyde d'étain, un corps fritté, un procédé de préparation de celle-ci et son utilisation. Le corps fritté selon US5071800 est utilisé en tant que cible de pulvérisation cathodique pour la formation d'un film électroconducteur transparent par le procédé de pulvérisation cathodique.

Il existait donc un besoin pour un procédé de préparation d'un élément cible de type céramique dépourvu d'au moins un des inconvénients des procédés de l'art antérieur.

Il existait également un besoin pour la mise à disposition d'un tel procédé, susceptible d'être mis en oeuvre par des personnes n'ayant pas de compétences particulières dans l'art de la céramique ou du frittage, ce procédé devant avantageusement conduire à l'obtention de cibles ou d'éléments de cible permettant notamment de réaliser facilement des cibles de grande surface.

Il existait aussi un besoin pour un procédé permettant l'obtention aisée de céramiques denses, et ce avantageusement en une seule étape de chauffage, sans avoir recours à la technique coûteuse du hot pressing (deuxième procédé), ou au démoulage délicat d'une cible compactée avant son frittage (premier procédé).

**SOMMAIRE**

La céramique de la présente invention est obtenue par un procédé de préparation d'une céramique à partir d'un matériau inorganique de base qui est sous forme d'une poudre ayant un point de fusion élevé qui est de préférence supérieur à 300 °C. Ce procédé ne fait pas partie de l'invention.

Le procédé comprend au moins:

- une étape de mélange de la poudre du matériau inorganique de base, de préférence sous forme pulvérulente, avec un deuxième composant inorganique, lui aussi sous forme de poudre, qui joue le rôle de dopant du matériau inorganique de base, ledit dopant étant constitué par un seul matériau inorganique ou par un mélange d'au moins deux matériaux inorganiques ayant un effet dopant sur le matériau inorganique de base; et
- une étape de frittage réalisée à une température élevée qui est préférentiellement supérieure à 800°C, et plus préférentiellement encore à 1000°C;

ledit procédé étant caractérisé en ce que les forces exercées sur les poudres, au cours de la préparation du mélange desdites poudres, sont inférieures ou égales à 5 kg/cm$^2$, de préférence inférieures à 1 kg/m$^2$.

De préférence, ladite poudre a une granulométrie caractérisée par une d50 comprise entre 10 nanomètres et 50 micromètres, plus préférentiellement encore entre 20 nanomètres et 30 micromètres.

Le dopant inorganique peut avantageusement contenir un ou plusieurs cations ayant un degré d'oxydation inférieur au cation (ou aux cations) constituant le matériau inorganique de base.

Préférentiellement, le rapport molaire du dopant peut, par rapport à celui du composant inorganique de base, varier entre 0,001 et 0,4, et il est préférablement situé entre 0,01 et 0,1.

Selon une autre variante préférentielle du procédé :

- dans une première étape, un mélange du matériau inorganique de base, dopé avec au moins un dopant, est disposé dans un contenant résistant à des températures supérieures à 1100°C, préférentiellement supérieures à 1300°C, sous forme de poudre non compactée ou très faiblement compactée, de préférence sous l'action d'une pression inférieure à 5 kg/cm$^2$, plus préférentiellement encore sous l'action d'une force inférieure à 1 kg/m$^2$; et
- dans une deuxième étape de frittage et/ou de recuit, le contenant préparé dans l'étape précédente est porté à une température élevée qui est inférieure à la température de fusion du matériau constitutif de l'élément cible (cette température est de préférence supérieure à 800°C et inférieure à 1700°C) et pendant une durée qui est de préférence comprise entre 1 et 100 heures, plus préférentiellement encore d'environ 12 heures, à atmosphère ambiante et plus préférentiellement encore sous une atmosphère inerte qui est avantageusement constituée d'argon.

Le contenant résistant utilisé peut avantageusement être constitué par un creuset ou moule, résistant aux hautes températures, de préférence jusqu'à 1600°C, et constitué de préférence d'alumine.

Le frittage peut avantageusement être conduit à une céramique suffisamment dense pour pouvoir être utilisée en tant que cible ou élément de cible pour pulvérisation cathodique.

Le matériau inorganique de base peut être choisi de préférence dans le groupe constitué par les oxydes, les oxyhalogénures tel qu'un oxychlorure ou/et oxyfluorure ou/et oxysulfure, et les mélanges d'au moins deux de ces derniers.

Les oxydes peuvent avantageusement être choisis dans le groupe constitué par $TiO_2$, $SnO_2$, $In_2O_3$, $Li_4Ti_5O_{12}$, $MoO_3$, $WO_3$, $Cr_2O_3$, $Fe_2O_3$, $Li_xNiO_2$ avec x compris entre 0,1 et 2 et de préférence égal à 1, $Li_xCrO_{2,5}$ avec x compris entre 1 et 2, et de préférence égal à 1, $LiFeO_2$ et les mélanges d'au moins deux de ces derniers.

De préférence, pour la réalisation du procédé, le dopant J est au moins un métal des groupes I à VIII du Tableau Périodique et qui possède un degré d'oxydation m inférieur à celui d'un des éléments-cations du matériau de base, à savoir : $m < k$ pour $E_\alpha{}^k O\beta^{2-}$ et $m < q$ ou/et $m < n$ pour $M_x{}^q T_y{}^n O_z{}^{2-}$.

Les couples (matériau inorganique de base, dopant créant les lacunes dans la matière inorganique) peuvent avantageusement être choisis dans le groupe constitué par :

- $W^{6+}$ comme cation du matériau de base en association avec au moins un cation dopant choisi dans le groupe

constitué par $Nb^{5+}$, $Ta^{5+}$, $V^{5+}$, $Ti^{4+}$, $Sn^{4+}$, $Mn^{4+}$, $Mg^{2+}$, $Zn^{2+}$, $Ni^{3+}$, $Ni^{2+}$, $Cu^{2+}$, $Co^{3+}$, $Co^{2+}$, $Fe^{3+}$, $Cr^{3+}$ et $Mn^{3+}$;

- $Mo^{6+}$ comme cation du matériau de base en association avec au moins un cation dopant choisi dans le groupe constitué par $Nb^{5+}$, $Ta^{5+}$, $V^{5+}$, $Ti^{4+}$, $Sn^{4+}$, $Mn^{4+}$, $Mg^{2+}$, $Zn^{2+}$, $Ni^{3+}$, $Ni^{2+}$, $Cu^{2+}$, $Co^{3+}$, $Co^{2+}$, $Fe^{3+}$, $Cr^{3+}$ et $Mn^{3+}$;
- $V^{5+}$ comme cation du matériau de base en association avec au moins un cation dopant choisi dans le groupe constitué par $Ti^{4+}$, $Sn^{4+}$, $Mn^{4+}$, $Ni^{3+}$, $Co^{3+}$, $Fe^{3+}$, $Cr^{3+}$, $Mn^{3+}$, $Zn^{2+}$, $Mg^{2+}$, $Ni^{2+}$, $Cu^{2+}$ et $Co^{2+}$;
- $Nb^{5+}$ comme cation du matériau de base en association avec au moins un cation dopant choisi dans le groupe constitué par $Ti^{4+}$, $Sn^{4+}$, $Mn^{4+}$, $Ni^{3+}$, $Co^{3+}$, $Fe^{3+}$, $Cr^{3+}$, $Mn^{3+}$, $Zn^{2+}$, $Mg^{2+}$, $Ni^{2+}$, $Cu^{2+}$ et $Co^{2+}$;
- $Ta^{5+}$ comme cation du matériau de base en association avec au moins un cation dopant choisi dans le groupe constitué par $Ti^{4+}$, $Sn^{4+}$, $Mn^{4+}$, $Ni^{3+}$, $Co^{3+}$, $Fe^{3+}$, $Cr^{3+}$, $Mn^{3+}$, $Zn^{2+}$, $Mg^{2+}$, $Ni^{2+}$, $Cu^{2+}$ et $Co^{2+}$;
- $Mn^{3+}$ comme cation du matériau de base en association avec au moins un cation dopant choisi dans le groupe constitué par $Zn^{2+}$, $Mg^{2+}$, $Cu^{2+}$, $Co^{2+}$, $Mn^{2+}$ et $Fe^{2+}$;
- $Co^{3+}$ comme cation du matériau de base en association avec au moins un cation dopant choisi dans le groupe constitué par $Zn^{2+}$, $Mg^{2+}$, $Cu^{2+}$, $Co^{2+}$, $Mn^{2+}$ et $Fe^{2+}$;
- $In^{3+}$ comme cation du matériau de base en association avec au moins un cation dopant choisi dans le groupe constitué par $Zn^{2+}$, $Mg^{2+}$, $Sn^{4+}$, $Cu^{2+}$, $Co^{2+}$, $Mn^{2+}$ et $Fe^{2+}$;
- au moins un cation du matériau de base choisi dans le groupe constitué par $Co^{2+}$, $Fe^{2+}$, $Zn^{2+}$, $Mg^{2+}$, $Cu^{2+}$, $Ni^{2+}$ et $Mn^{2+}$ en association avec le cation $Li^+$; et
- tous les mélanges des matériaux inorganiques de base précédemment énumérés en association avec les dopants compatibles précédemment énumérés.

Le procédé est particulièrement adapté pour la préparation de céramiques ayant une surface supérieure à 4 $cm^2$, et de préférence comprise entre 5 et 1000 $cm^2$.

De façon avantageuse, lors de la mise en œuvre du procédé le mélange des poudres, de préférence le mélange de $In_2O_3$, $SnO_2$ et ZnO, peut être réalisé en présence d'un solvant organique ou aqueux ou d'un mélange d'au moins un solvant organique et un solvant aqueux.

Le solvant organique peut de préférence être choisi dans le groupe constitué par les alcools, les cétones, les éthers et les mélanges d'au moins deux de ces derniers.

Le solvant peut de préférence être un éther choisi parmi l'éther, l'éthanol, l'acétone et les mélanges d'au moins deux de ces derniers.

De préférence, le solvant peut être de type aqueux à base d'eau distillée et/ou désionisée.

Selon un autre mode avantageux de réalisation du procédé la quantité de solvant organique utilisée pour réaliser le mélange de poudres céramiques peut être comprise entre 5 mL et 5L (Litres), de préférence entre 800 et 1200 mL, par kg de mélange de poudre.

Plus avantageusement encore, 50 mL d'éthanol peut être mélangé à 0,05 kg d'un mélange de $In_2O_3$, $SnO_2$ et ZnO.

Selon un autre mode particulièrement intéressant de réalisation du procédé la résistivité de la céramique obtenue dans ledit procédé peut être ajustée par réglage de la teneur en au moins un des dopants présents dans le mélange de poudres utilisé comme matériau inorganique de base, lesdits dopants étant tels que définis de façon isolée, ou en association, dans l'aspect le plus large de l'invention. Ainsi, des céramiques obtenues présentent des résistivités faibles (respectivement élevées) pour des valeurs élevées (respectivement faibles), en au moins un des matériaux inorganiques de base dopants choisi de préférence dans le groupe constitué par le $Zn^{2+}$, $Mg^{2+}$, $Cu^{2+}$, $Co^{2+}$, $Mn^{2+}$ et $Fe^{2+}$, plus préférentiellement encore le $Zn^{2+}$. De préférence, la résistivité minimum de la céramique (qui est d'environ $1,7 \times 10^{-3}$ $\Omega$.cm dans le cas des céramiques contenant du $Zn^{2+}$) est obtenue pour des valeurs nominales minimales de 10 mole % de la teneur en au moins un des matériaux inorganiques de base dopants tels que définis de façon isolée ou en association, dans l'aspect le plus large de l'invention (de préférence le dopant est choisi dans le groupe constitué par $Zn^{2+}$, $Mg^{2+}$, $Cu^{2+}$, $Co^{2+}$, $Mn^{2+}$ et $Fe^{2+}$, plus préférentiellement encore le $Zn^{2+}$).

Selon une autre variante d'un intérêt particulier du procédé la mobilité de charge de la céramique obtenue dans ledit procédé peut être ajustée par réglage de la teneur en dopants présents dans le mélange de poudres utilisé comme matériau inorganique de base, lesdits dopants étant tels que définis de façon isolée ou en association dans l'aspect le plus large de l'invention. De préférence, le dopant est choisi dans le groupe constitué par le $Zn^{2+}$, $Mg^{2+}$, $Cu^{2+}$, $Co^{2+}$, $Mn^{2+}$ et $Fe^{2+}$, plus préférentiellement encore le $Zn^{2+}$, et la mobilité de charge augmente lorsque la teneur en dopants présents dans le mélange de poudres utilisé comme matériau inorganique de base augmente (jusqu'à 10 % dans le cas de $Zn^{2+}$).

Selon une autre variante d'un intérêt particulier, la mobilité de charge obtenue dans ledit procédé peut être réglée par réglage de la percolation de grain (de préférence en Zn) dans le mélange de poudre utilisé comme matériau inorganique de base, des mobilités de charge élevées étant obtenues pour des valeurs élevées de percolation de grain, de faibles mobilités de charge étant obtenues pour de faibles valeurs de percolation de grain.

Le procédé présente notamment les avantages de permettre l'obtention de céramiques sous forme de pellets, de préférence de forme cylindrique. Le procédé de l'invention présente aussi l'avantage d'être rapide, simple et peu onéreux.

L' objet de la présente invention est une céramique selon la revendication 1.

Une sous-famille préférentielle des céramiques de l'invention est constituée par les céramiques ayant une très forte cristallinité qui, mesurée selon la méthode de diffraction X (en utilisant un goniomètre vertical Philips PW1820 dans une géométrie Bragg Brentano avec une radiation $CuK\alpha$-$\lambda$ = 1,5406 Å; la taille des cristallites a aussi été déterminée par Microscope Électronique à balayage de type JEOL JSM-6700F microscope), correspond de préférence à une taille des cristallites comprise entre 100 et 200 nm et plus préférentiellement à une taille de cristallites d'environ 156 nm.

Une autre sous-famille préférentielle des céramiques de l'invention est constituée par les céramiques présentant une structure cristalline de type bixbyite, aussi appelée structure d'oxyde de terre rare de type c.

Une autre sous-famille préférentielle de l'invention est constituée par les céramiques possédant au moins une propriété électrique améliorée par rapport à des céramiques de type ITO.

Les céramiques de l'invention peuvent avantageusement présenter une conductivité qui, mesurée selon la méthode à quatre points et en fonction de la température variant de 4,2 K à température ambiante, est comprise entre 200 et 10000, de préférence entre 300 et 5000 siemens par cm, et plus préférentiellement encore d'environ 580 siemens par cm.

De préférence, les céramiques de l'invention présentent des propriétés électriques améliorées par rapport à la céramique de type ITO.

Les céramiques de l'invention peuvent avantageusement présenter une mobilité de charge améliorée qui, mesurée selon la méthode de l'effet Seebeck, est comprise entre 0,01 et 300, et de préférence comprise entre 0,1 et 50 $cm^2$/vol.s$^{-1}$.

Les céramique de l'invention caractérisée par une mobilité de charge supérieure à 10,1 $cm^2$/vol.s$^{-1}$ présentent un intérêt particulier.

Les céramiques de l'invention obtenues à partir d'un mélange contenant 82,23 mol. % de matériau inorganique de base de formule $In_2O_3$ et 8,66 mol. % de dopant $SnO_2$ et 9,11 mol. % de dopant ZnO, ce dernier dopant (ZnO) assurant la densification, sont particulièrement intéressantes et se caractérisent par :

- une conductivité électrique comprise entre 300 et 500 siemens par cm et de préférence d'environ 330 siemens par cm;
- une densité comprise entre 6 et 7,1 $g/cm^3$, et de préférence d'environ 6,57 $g/cm^3$;
- une surface (totale) comprise entre 1 et 1000 $cm^2$; et
- un pourcentage d'irrégularités compris entre 5 et 20 %, et de préférence inférieur à 10 %.

La conductivité de ces céramiques peut avantageusement être supérieure à 70 %, de préférence comprise entre 80 % et 100 %, et plus avantageusement supérieure à 90 % de la conductivité théorique. Ces céramiques comportent de préférence des pourcentages molaires en $SnO_2$ et ZnO compris entre 3 % et 15 % avec un pourcentage en ZnO supérieur ou égal à celui de $SnO_2$. De préférence, le pourcentage en ZnO est supérieur à celui de $SnO_2$.

Un deuxième objet de la présente invention est constitué par l'utilisation d'une céramique obtenue par un procédé tel que défini ci-dessus, ou telle que définie dans le premier objet de la présente invention, comme cible pour pulvérisation cathodique RF ou DC et PLD (Pulse Laser Deposite) techniques et PVD (Physical Vapor Deposition) techniques.

La présente invention couvre indifféremment les utilisations en laboratoire et en production industrielle.

Un troisième objet de la présente invention est constitué par un procédé de préparation d'un film transparent et conducteur métallique par pulvérisation d'au moins une céramique telle qu'obtenue par mise en œuvre d'un procédé tel que défini ci-dessus, ou telle que définie dans le premier objet de l'invention.

La pulvérisation peut avantageusement être conduite dans des conditions de température comprise entre 25 et 500°C, et de préférence à température ambiante.

La durée de la pulvérisation peut avantageusement être comprise entre 1 minute et 10 heures. De préférence, elle est d'environ 1 heure.

La pulvérisation peut avantageusement être réalisée dans une atmosphère majoritairement constituée de gaz rares, de préférence dans une atmosphère constituée de 99,8 % d'argon et de 0,2 % d'oxygène.

La densité de puissance de pulvérisation peut préférentiellement être comprise entre 0,1 et 15 Watts/$cm^2$, de préférence d'environ 0,5 Watts/$cm^2$.

La distance entre la cible de céramique et le substrat sur lequel le film mince est déposé peut, de préférence, être comprise entre 3 et 15 cm, et elle est plus avantageusement d'environ 7 cm.

Un film et/ou une électrode transparent(e) peut être obtenu(e) par mise en œuvre d'un procédé tel que défini dans le troisième objet de la présente invention. Le film peut constituer un film électrode transparent ou un film transparent.

Un film électrode transparent peut être obtenu par pulvérisation sur des dispositifs optoélectroniques comme des cellules solaires, des diodes émettant une lumière organique (organic light emitting diode), OLLED flexible, cellules solaires photovoltaïques à base de polymère, etc.

Une sous-famille avantageuse de films et/ou électrodes peut être constituée par les films ou électrodes présentant un coefficient de transmission qui, mesuré selon la méthode du spectre de transmission des films dans la région UV-visible-NIR (enregistré en utilisant un Spectromètre de type Carry 5000 dans la gamme 200-2500 nm), est dans le visible et compris entre 90 et 100 %. De préférence, le coefficient de transmission est supérieur à 95 %.

De préférence, les films ou électrodes présentent une conductivité qui, mesurée selon la méthode à quatre points, est supérieure ou égale à 1000 siemens/cm, plus avantageusement encore supérieure à 2250 siemens/cm.

Une autre sous-famille particulièrement intéressante de films ou électrodes peut être constituée par les films ou électrodes obtenus à partir d'une céramique cible choisie parmi les céramiques de formule :

- $In_{1,805}Sn_{0,095}Zn_{0,10}O_{3-\delta}$ (conductrice) avec $\delta$ compris de préférence entre 0,001 et 0,03, plus préférentiellement encore à environ 0,005 ;
- $In_{1,94}Zn_{0,06}O_{297}$ (conductrice), $Li_4Ti_{4,5}Mg_{0,5}O_{11,5}$ (isolante, i.e. avec une conductivité inférieure à $10^{-4}$ S/cm) ; $Li_4Ti_{4,5}Zn_{0,5}O_{11,5}$ (isolante, i.e. avec une conductivité inférieure à $10^{-4}$ S/cm) ;
- $Li_4Ti_{4,5}Ni_{0,5}O_{11,75}$ (isolante, i.e. avec une conductivité inférieure à $10^{-4}$ S/cm) ; et
- les mélanges d'au moins deux de ces dernières céramiques.

## DESCRIPTON BRÈVE DES DESSINS

Figures 1A, 1B, 1C, 1D et 1E représentent différentes étapes mises en œuvre pour la réalisation d'une céramique haute densité selon l'invention ainsi que des photos d'un creuset rempli du mélange de poudre compacté défini dans l'exemple 1' et la céramique correspondante obtenue après traitement thermique de la poudre compactée selon la méthode de l'invention.

Figures 2A et 2B représentent une photo MEB d'une céramique ITO (Figure 2A) obtenue dans l'exemple 0 selon la technique de l'art antérieur et une photo de la céramique ITZO (Figure 2B) obtenue dans l'exemple 1', par traitement de la même poudre additionnée d'un l'élément dopant.

Figure 3 est un schéma représentant le procédé de pulvérisation cathodique traditionnel (RF) et les différents éléments impliqués.

Figure 4 représente les résistivités électriques obtenues pour la céramique ITO préparée dans l'exemple 0 (courbe du haut) et pour la céramique ITZO préparée dans l'exemple 1' (courbe du bas).

Figure 5 est un diagramme de diffraction aux rayons X pour les poudres frittées ITZO ayant la composition nominale $[In_2O_3:Sn_{0,10}]:Zn_y$, $0 \leq y \leq 0,10$, ($\downarrow$) indiquant les pics qui correspondent au $SnO_2$ rutile.

Figure 6 montre le déplacement du pic de rayon X (222) pour les poudres frittées ITZO en comparaison avec l'équivalent ITO (diagramme de référence JCPDS 89-4596).

Figures 7A, 7B, 7C et 7D représentent des micrographes MEB (SEM) pour les céramiques ayant les compositions nominales suivantes : (7A) $In_2O_3:Sn_{0,10}$ ; (7B) $[In_2O_3:Sn_{0,10}]:Zn_{0,04}$ ; (7C) $[In_2O_3:Sn_{0,10}]:Zn_{0,08}$ ; et (7D) $[In_2O_3:Sn_{0,10}]:Zn_{0,10}$.

Figure 8 représente un modèle schématisé de la bande d'énergie pour Sn qui dope $In_2O_3$ pour une concentration de dopage petite et importante (x) (selon l'estimation dans le document [11] dans lequel 0,015 mol. % est une valeur seuil).

Figure 9 représente l'évolution de la résistivité avec la température pour différentes teneurs nominales en Zn ($Zn_y$) dans la céramique ITZO ($[In_2O_3:Sn_{0,10}]:Zn_y$) avec $0 \leq y \leq 0,10$, l'évolution de la résistivité à température ambiante étant montrée dans l'encart.

Figure 10 représente l'évolution du coefficient de Seebeck avec la température pour différentes teneurs nominales en Zn dans la céramique ITZO ($[In_2O_3:Sn_{0,10}]:Zn_y$) avec $0 \leq y \leq 0,10$.

Figure 11 représente des données d'analyse thermogravimétrique (TGA) pour $In_2O_3:Sn_{0,10}$ (ITO) et

[In$_2$O$_3$:Sn$_{0,10}$]:Zn$_{0,10}$ (ITZO) (composition nominale).

Figure 12 représente une variation de la densité apparente relative (d/d$_0$) avec Zn$_y$ pour les céramiques [In$_2$O$_3$:Sn$_{0,10}$]:Zn$_y$.

Figure 13 est une représentation schématique des cations des sites b et des cations des sites d dans la structure type bixbyite, avec des anions du réseau et des lacunes structurales.

Figure 14 représentent des données de diagramme de diffraction de rayons X pour (a) In$_2$O$_3$ non dopé et (b) les poudres In$_2$O$_3$:Sn$_{0,01}$ (ITO) recuites à 1300°C, le changement du pic ITO (222) étant montré dans l'encart, ($\downarrow$) indiquant les pics qui correspondent au SnO$_2$ rutile.

Figures 15A, 15B, 15C et 15D sont une représentation schématique de la préparation de la céramique dense ITZO, la Figure 15A étant une photographie du mélange de poudres légèrement pressées dans un creuset en alumine, la Figure 15B étant une photographie de la céramique dense ITZO obtenue après frittage, montrant le retrait, la température de frittage étant de 1300°C pendant 12 heures, les Figures 15C et 15D étant des schémas correspondants aux photographies.

Figure 16 représente l'évolution de la résistivité avec la température pour différentes teneurs nominales (Zn$_y$) en Zn dans la céramique ITZO ([In$_2$O$_3$:Sn$_{0,10}$]:Zn$_y$) avec $0 \leq y \leq 0,10$, l'évolution de la résistivité à température ambiante étant montrée dans l'encart, $y = 0$ (In$_2$O$_3$:Sn$_{0,10}$) représentant la céramique ITO.

Figure 17 représente l'influence de la densité de puissance sur la vitesse de dépôt des films minces ITZO (p$_{o2}$ = 0,2%).

Figure 18 représente la pression partielle en oxygène sur la vitesse de dépôt des films minces ITZO (P = 1 W/cm$^2$).

Figure 19 représente le spectre de transparence pour les films minces ITZO déposés à différentes densités de puissance (p$_{o2}$ = 0,2 %), l'épaisseur de film étant fixée à environ 400 nm pour tous les films, l'encart montrant la région visible étendue montrant la transparence.

Figure 20 représente la détermination de l'énergie optique de la bande interdite pour le film mince ITZO à diverses densités de puissance.

Figure 21 représente la transmission optique pour différents films minces préparés sous diverses pressions partielles en oxygène (P = 0,5 W/cm$^2$), les épaisseurs des films étant comprises entre 250 et 280 nm.

Figure 22 représente la détermination de l'énergie optique de la bande interdite pour le film mince ITZO déposé sous différentes pressions partielles en oxygène.

Figure 23 représente l'évolution de la résistivité avec la densité de puissance (p$_{o2}$ = 0,2 %).

Figure 24 représente l'évolution de la résistivité comme une fonction de la pression partielle en oxygène pour les films minces (P = 0,5 W/cm$^2$).

Figure 25 représente le diagramme de diffraction de rayons X des films minces ITZO sur un substrat en verre à différentes densités de puissance, le diagramme de diffraction aux rayons X de ITO (référence JCPDS no. 89-4956) étant donné à titre de comparaison (lignes verticales).

Figures 26A, 26B et 26C représentent les micrographes MEB pour le film mince ITZO déposé avec une puissance de pulvérisation RF de 0,5 W/cm$^2$ (Figure 26A), 1,5 W/cm$^2$ (Figure 26B) et 2,5 W/cm$^2$ (Figure 26C).

Figure 27A, 27B et 27C représentent les images AFM pour le film mince ITZO déposé à différentes puissances de pulvérisation : 0,5 W/cm$^2$ (Figure 27A), 1,5 W/cm$^2$ (Figure 27B) et 2,5 W/cm$^2$ (Figure 27C), à différentes échelles de l'axe z.

Figures 28A et 28B représentent les images AFM pour le film ITO-verre (Figure 28A) et le film ITZO-PET (Figure 28B), à différentes échelles de l'axe z.

Figure 29 représente les diagrammes de diffraction de rayons X pour les films minces ITZO sur un substrat en verre (ITZO-Verre), ou sur le substrat en plastique (ITO-PET), le diagramme de diffraction de rayons X du substrat PET étant donné à titre de comparaison.

Figure 30 représente la transmission optique pour les films minces ITZO-Verre qui ont des épaisseurs différentes, la transparence de ITO-Verre étant donnée à titre de comparaison.

Figure 31 représente la transmission optique pour les films minces ITZO-PET qui ont des épaisseurs différentes, la transparence de ITO-PET étant donnée à titre de comparaison.

Figure 32 représente la réflexion IR optique pour les films minces ITZO déposés sur des substrats en verre (ITZO-Verre (260nm) et en plastique (ITZO-PET (260nm)), les courbes de réflectivité de ITO-Verre commercial (100 nm) et ITO-PET (200 nm) étant données à titre de comparaison.

Figure 33 montre l'évolution de la résistivité avec la température pour les films minces ITZO déposés sur un substrat en plastique (ITZO-PET) et en verre (ITZO-PET), l'épaisseur de film étant de 260 nm.

Figure 34 montre le matériel utilisé pour la mise en oeuvre de la méthode "ball-milling" utilisée dans les exemples.

## DESCRIPTION DÉTAILLÉE DES RÉALISATIONS PRÉFÉRÉES

Dans le cadre de la présente divulgation, les aspects suivants sont considérés.

Le matériau inorganique formant l'élément de base de cible peut être tout spécialement un oxyde, mais il peut être aussi un oxyhalogénure tel qu'un oxychlorure ou/et oxyfluorure ou/et oxysulfure et, notamment, un oxyde ayant l'une ou l'autre des formules $E_\alpha^k O_\beta^{2-}$ et $M_x^q T_y^n O_z^{2-}$.

Le dopage créé dans le matériau de base a pour but de générer des lacunes anioniques dans le matériau de base, favorisant ainsi l'obtention de céramiques denses (de densité comprise entre 70 et 100 % et de préférence supérieure ou égale à 90 %). Il faut donc, conformément à l'invention, que le cation du dopant ait un degré d'oxydation m (nombre réel) impérativement inférieur à celui du cation dans le matériau de base, c'est-à-dire m < k dans $E_\alpha^k O_\beta^{2-}$ et m < q ou/et m < n dans $M_x^q T_y^n O_z^{2-}$. Les formules des matériaux dopés et ayant donc des lacunes anioniques propices au frittage sans compactage (ou faible) préalable, peuvent ainsi s'écrire, avec J désignant le dopant et m son degré d'oxydation :

1) pour $E_\alpha^k O_\beta^{2-}$ qui désigne le matériau de base : $E_{\alpha-x'}^k J_{x'}^m O_{\beta-x'(k-m)/2}^{2-} \square_{x'(k-m)/2}$ qui désigne le matériau dopé, avec :

- les lacunes anioniques désignées par $\square$;
- x' qui désigne le taux de substitution est inférieur à $\alpha$ (de préférence supérieur ou égal à $0{,}005\alpha$); et

2) pour $M_x^q T_y^n O_z^{2-}$ qui désigne le matériau de base : la formule $M_{x-x'}^q J_{x'}^m T_y^n O_{z-x'(q-m)/2}^{2-} \square_{x'(q-m)/2}$ ou $M_x^q T_{y-x'}^n J_{x'}^m O_{z-x'(n-m)/2}^{2-} \square_{x'(n-m)/2}$ ou/et Une combinaison des deux formules qui désignent le matériau dopé, avec :

- x' qui désigne le taux de substitution qui est inférieur à x dans la formule $M_{x-x'}^q J_{x'}^m T_y^n O_{z-x'(q-m)/2}^{2-} \square_{x'(q-m)/2}$ comme indiqué dans la divulgation (de préférence supérieur ou égal à 0,005x);
- x' est inférieur à y dans la formule $M_x^q T_{y-x'}^n J_{x'}^m O_{z-x'(n-m)/2}^{2-} \square_{x'(n-m)/2}$, de préférence x' étant supérieur ou égal à 0,005y.

On remarquera que les lacunes anioniques que l'on crée ne portent pas de charge, alors que les autres éléments portent une charge, par exemple l'oxygène porte la charge négative 2-; le cation M porte la charge positive q; le cation T porte la charge positive n; etc.

Le procédé permet la préparation, à partir d'un matériau inorganique de base, d'un élément de cible pour pulvérisation cathodique. Il consiste à ajouter, au matériau inorganique de base, un autre matériau inorganique de type dopant. Ce matériau inorganique contient avantageusement un ou plusieurs cations ayant de préférence un degré d'oxydation inférieur au cation (ou aux cations) constituant le matériau inorganique de base.

Le mélange de poudre ainsi obtenu n'est soumis à aucune force particulière ou seulement à celles nécessaires pour en réaliser un léger compactage.

Le rapport atomique du dopant par rapport à celui du matériau inorganique de base varie de préférence entre 0,005 et 0,2, et il est avantageusement situé entre 0,05 et 0,06.

Le matériau inorganique de base ainsi dopé est simplement disposé sous forme de poudre compactée ou non compactée dans un creuset ou moule approprié, résistant aux hautes températures, de préférence jusqu'à 1600°C. Un tel creuset ou moule peut être par exemple à base d'alumine. Le frittage du matériau inorganique dopé, ainsi disposé, a lieu lorsque le creuset ou moule est porté à une température élevée (supérieure à 800°C et inférieure au point de fusion du matériau de base).

Il a été trouvé que de façon inattendue, le frittage conduit à une céramique suffisamment dense pour pouvoir être utilisée en tant que cible ou élément de cible pour pulvérisation cathodique.

Sans être lié par la théorie, les formules sont présentées dans cette divulgation comme étant une représentation des céramiques préférentielles obtenues par la mise en oeuvre des procédés tels que décrits ci-dessus.

Dans les formules, E est au moins un métal des groupes I à VIII du Tableau Périodique des Éléments, par exemple Fe, Cu, Co, Ni, W, Mo, Ti, Cr, Sn et In. M et T désignent au moins deux métaux différents du Tableau Périodique, par exemple Li, Na, K, Ag, Cu et Tl pour M et Ni, Co, W, Mn, Cr, Fa, V et Ti pour T. Les symboles k, q et n désignent les degrés d'oxydation moyens de E, M et T respectivement. Les paramètres $\alpha$ et $\beta$ sont des nombres entiers positifs vérifiant la formule $\alpha k - 2\beta = 0$ et x, y et z désignent des nombres entiers positifs tels que $qx + ny - 2z = 0$.

Comme exemples de tels oxydes on peut citer, à titre non limitatif, $TiO_2$, $In_2O_3$, $Li_4Ti_5O_{12}$, $MoO_3$, $Cr_2O_3$, $Fe_2O_3$, $Li_xNiO_2$, $Li_xCrO_2$, $Li_xCoO_2$, et $LiFeO_2$.

Le dopant J, responsable de la densification, est de préférence au moins un métal des groupes I à VIII du Tableau Périodique mais qui possède impérativement, à l'état de cation, un degré d'oxydation m inférieur à celui d'un des éléments-cations du matériau de base, à savoir : $0 < m < k$ pour $E_\alpha{}^kO_\beta{}^{2-}$ et $0 < m < q$ ou/et $0 < m < n$ pour $M_x{}^qT_y{}^nO_z{}^{2-}$.

Il a été découvert de façon surprenante que le dopage du composé $E_\alpha{}^kO_\beta{}^{2-}$ par un oxyde (ou halogénure ou oxyhalogénure) ayant l'élément dopant $J^m$ partiellement substitué à E, selon les proportions précitées appelées ici x' (avec x' forcément inférieur à $\alpha$, soit $0 < x' < a$), engendre la formation de lacunes anioniques $y\square$, selon $E_{(\alpha-x)}{}^kJ_x{}^mO_{\beta-y}{}^{2-}\square_y$; y est alors forcément un nombre positif inférieur à $\beta$ tel que $2y \cong x'(k-m)$, soit $y = x'(k-m)/2$. Par exemple, pour $TiO_2$, le dopant peut être ZnO ou MgO. En effet, le zinc et le magnésium ont un degré d'oxydation égal à +2, c'est à dire inférieur au degré d'oxydation +4 du titane. Dans le cas de MgO utilisé comme dopant par exemple, on écrira: $Ti_{1-x'}Mg_{x'}O_{2-x'}\square_{x'}$, pour $TiO_2$ ainsi dopé. L'indice x' peut varier entre 0,0053 et 0,2 et de préférence varie de 0,05 à 0,06, ce qui correspond sensiblement à un taux de dopant, mesuré par mole (ou atome) de Ti, ou par mole de $TiO_2$, compris entre 0,5 et 20 %, et de préférence de 5 à 6 %.

Ces lacunes anioniques qui sont neutres, c'est à dire non chargées, favorisent la densification du matériau final obtenu lors de son chauffage ou recuit dans les conditions précitées. De la même manière, le dopage du composé $M_x{}^qT_y{}^nO_z{}^{2-}$ par un oxyde (ou halogénure ou oxyhalogénure) ayant l'élément dopant $J^m$ partiellement substitué à T, selon les proportions précitées appelées ici x' (avec x' forcément inférieur à y), semble engendrer la formation de lacunes anioniques $y\square$, selon $M_x{}^qT_{(y-x')}{}^nJ_{x'}{}^mO_{(x-y)}{}^{2-}\square_y$; y est alors forcément un nombre positif inférieur à z tel que $2y \cong 2x'(n-m)$, soit $y \cong x'(n-m)/2$. Par ailleurs, et de la même manière, le dopage du composé $M_x{}^qT_y{}^nO_z{}^{2-}$ par un oxyde (ou. halogénure ou oxyhalogénure) ayant l'élément dopant $J^m$ partiellement substitué à M , selon les proportions précitées appelées ici x' (avec x' forcément inférieur à x), semble engendrer la formation de lacunes anioniques $y\square$, selon $M_{(x-x')}{}^qJ_{x'}{}^mT_ynO_{(z-x')}{}^{2-}\square_y$; y est alors forcément un nombre positif inférieur à x' qui vérifie la relation $2y = x'(q-m)$, soit $y \cong x'(q-m)/2$. Le dopant (ou les dopants) J peuvent être partiellement substitué(s) à la fois à M et T. Les formules correspondantes résultent alors de la combinaison des deux formules précitées. Ces lacunes anioniques favorisent la densification du matériau final obtenu lors de son chauffage ou recuit dans les conditions précitées.

Par exemple pour $Li_4Ti_5O_{12}$, le dopant peut être ZnO ou MgO car le zinc et le magnésium ont un degré d'oxydation égal à +2, c'est à dire inférieur au degré d'oxydation +4 du titane.

Dans le cas de MgO utilisé comme dopant par exemple on écrira : $Li_4Ti_{5-x'}Mg_{x'}O_{12-x'}\square_{x'}$; pour $Li_4Ti_5O$ ainsi dopé, x' peut varier entre 0,025 et 1 et de préférence est égal à 0,25-0,3, ce qui correspond sensiblement à un taux de dopant, mesuré par mole (ou atome) de Ti compris entre 0,5 et 20 %, et de préférence 5 à 6 %.

Lorsque que le procédé de dopage par le zinc $Zn^{2+}$ ou d'autres cations ($Mg^{2+}$, $Cu^{2+}$, etc.) de degré d'oxydation inférieur à celui des oxyde base est appliqué aux oxydes suivants, ils conduisent à des oxydes nouveaux, notamment ceux qui ont des taux de dopage compris entre 0,5 et 20 % et de préférence compris entre 5 et 6 % :

- $TiO_2$, $MoO_3$, $WO_3$, $Cr_2O_3$ , $Fe_2O_3$, $Li_xNiO_2$ avec x compris entre 0,1 et 2 et de préférence égal à 1, $Li_xCrO_{2.5}$ avec x compris entre 1 et 2, et de préférence égal à 1, $LiFeO_2$; et
- $Li_4Ti_5O_{12}$, pour lequel le titane est au degré moyen d'oxydation +4, dopé par $Ni^{2+}$ ou/et $Ni^{3+}$; un codopage par Zn/Ni est également nouveau. Le taux de dopant est celui précité (compris entre 0,5 et 20 % et de préférence 5 à 6 %).

Selon un mode préférentiel de réalisation de l'invention, les films (ou électrodes) sont préparés par pulvérisation cathodique à partir des céramiques (ou cibles) de nouvelle composition $In_{1,805}Sn_{0,095}Zn_{0,10}O_3$. Ils donnent lieu, y compris sur support plastique tel que le PET, à des électrodes transparentes (90 % de transmission dans le visible) et conductrices (> 1000 siemens/cm) dont les performances sont remarquables.

Ce matériau présente une densité de 6,57 grammes/$cm^3$, ce qui correspond à 92 % de la densité théorique, mesurée selon la méthode du porosimètre à mercure (Autopore IV 9500 Mercury Porosimeter). Cette densité est largement suffisante pour que les céramiques puissent être utilisées en tant que cible pour pulvérisation cathodique. En deçà de 70 % de la densité théorique, les cibles tendent à se craqueler durant la pulvérisation et, par ailleurs, le plasma ne reste pas toujours homogène au cours du processus de pulvérisation conduisant à des films non homogènes en composition, et de ce fait non reproductibles. Cela n'est pas le cas pour des densités supérieures à 70 %, et de préférence supérieures à 80 % comme c'est le cas ici, puisque la densité est supérieure à 90 %.

La densité d'une céramique correspondante préparée sans ajout d'élément dopant par la méthode conventionnelle (pressage de la poudre a 1 t/cm$^2$ environ, et ensuite recuit en température à 1300°C) est de 5 g/cm$^3$, soit 70 % de la densité théorique. Dans ces conditions, il a été constaté qu'il est impossible de préparer une céramique sans les dopants précités par la méthode telle que décrite ci-dessus.

Il est par ailleurs précisé que les céramiques de ITO commerciales, qui ont une densité de l'ordre de 90 %, sont préparées par la technique lourde et coûteuse du "Hot-Pressing" de l'art antérieur.

Le procédé tel que décrit ci-dessis permet par conséquent de préparer des céramiques ayant des densités au moins aussi élevées, et ce, de façon beaucoup plus souple, simple et moins onéreuse que par les techniques connues de l'art antérieur.

Autre avantage, il est ainsi possible de préparer par la méthode telle que décrite ci-dessus, des céramiques ayant une importante surface qui peut être supérieure à 100 cm$^2$, et ce à condition d'utiliser les dopants précités.

Enfin les céramiques ainsi obtenues présentent des caractéristiques intrinsèques originales dont notamment une taille de pores qui est sensiblement supérieure (généralement pour 3 à 10 %, préférentiellement pour 4 à 5 %) à celle des céramiques similaires de l'art antérieur, bien que présentant des conductivités électrochimiques comparables.

Il est possible qu'il y ait d'autres explications pour expliquer la forte densité des matériaux céramiques obtenus.

EXEMPLES

Les exemples ci-après explicités sont donnés à titre illustratifs seulement et ne sauraient être interprétés comme constituants une quelconque limitation de l'objet de la présente invention.

Exemple 0 - Préparation d'une céramique ITO de type commercial

Pour préparer la cible (céramique) de ITO (Figure 2A) circulaire de 5 cm de diamètre et de composition In$_{1,9}$Sn$_{0,1}$O$_3$, et d'un poids égal à 50 grammes, on procède selon le protocole expérimental ci-après détaillé.

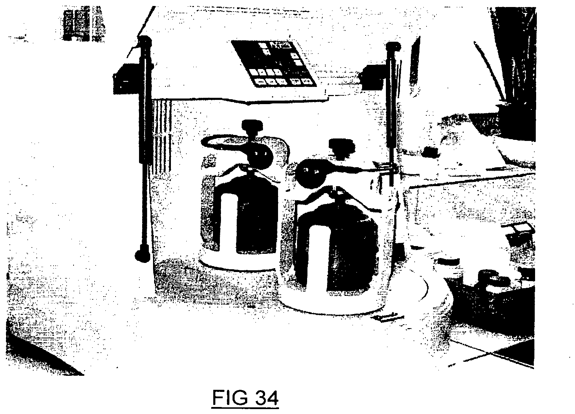

Étape 1) On mélange 47,3173 g de In$_2$O$_3$, 2,6827 g de SnO$_2$ en utilisant la technique bien connue dite de "ball-milling" avec l'appareil FRITSCH type 05.600; à cette fin, on met le mélange précité de poudre dans une des deux jattes en agate de la Figure 34 contenant chacune 50 boules de 8 mm de diamètre en agate; on ajoute 30 ml d'éthanol; on recouvre avec un couvercle en agate comme indiqué sur la figure; on effectue alors le "ball-milling" pendant 3 heures à 250 tours par minute comme indiqué sur la figure. On met ensuite la poudre ainsi mélangée dans l'éthanol dans un bécher et on sèche la poudre en la chauffant à 110°C pendant 8 heures à l'air.

Étape 2) On dispose la poudre dans un moule en acier inoxydable cylindrique de diamètre intérieur de 60 mm et on presse la poudre à 25 tonnes/cm$^2$ pendant 10 minutes. On obtient ainsi une cible compactée.

Étape 3) On amène délicatement (car très fragile) la cible compactée sur un support en alumine et on chauffe le support avec la cible à raison de 300°C par heure dans le four à moufle, présenté sur l'image à gauche, jusqu'à atteindre la température de 1300°C que l'on maintient pendant 12 heures; on refroidit ensuite à raison de 300°C par heure. On obtient alors la céramique désirée de ITO (Figure 2A), utilisable pour la pulvérisation cathodique.

Exemple 1 - Cibles de ITZO pour la préparation d'électrodes transparentes et métalliques pour dispositifs optoélectroniques

Selon un premier mode préférentiel de réalisation lorsque le matériau inorganique de base est l'oxyde In$_2$O$_3$ ou In$_2$O$_3$ dopé à l'étain (communément appelé ITO), pour lesquels l'indium est au degré moyen d'oxydation +3, le dopant peut avantageusement être l'oxyde de zinc ou l'oxyde de magnésium (préférable à un halogénure ou oxyhalogénure de zinc ou de magnésium, même si ces derniers présentent un certain intérêt) pour lesquels le degré d'oxydation du zinc ou du magnésium est +2, c'est-à-dire inférieur à celui +3 de l'indium.

Même lorsque le rapport molaire du dopant par rapport à celui de l'oxyde d'indium est aussi faible que 0,06, des céramiques suffisamment denses pour pouvoir être utilisées en tant que cible ou élément de cible pour pulvérisation cathodique, sont obtenues par simple chauffage (pouvant être à l'air) à des températures supérieures à 1100°C (idéalement 1300°C) suivant la méthode précitée et lorsque l'on maintient ledit ensemble à cette température pendant une durée suffisante pour transformer le système précurseur en ledit matériau inorganique céramique.

Par ailleurs, ces céramiques ont une conductivité électrique suffisamment élevée pour que la pulvérisation cathodique en mode DC (adaptée à l'échelle industrielle) puisse avantageusement être utilisée. On obtient ainsi par pulvérisation cathodique DC (ou RF) de ces cibles des films à propriétés optoélectroniques au moins égales à celles des céramiques ITO commercialisés.

Exemple 1' - semi-conducteur dégénéré ITZO pour la préparation d'électrodes transparentes et métalliques pour dispositifs optoélectroniques.

Pour préparer les cibles ITZO, dans l'exemple les cibles circulaires de 5 cm de diamètre et de composition $In_{1,805}Sn_{0,095}Zn_{0,10}O_3$ et d'un poids égal à 50 grammes, on procède selon trois étapes successives selon le protocole expérimental ci-après détaillé.

Dans l'étape 1) on mélange 45,8881 grammes de $In_2O_3$, 2,6217 grammes de $SnO_2$ et 1,4902 grammes de ZnO en utilisant la technique bien connue dite de "ball-milling"; à cette fin, on met le mélange précité de poudre dans une des deux jattes en agate de la Figure 34 contenant chacune 50 boules de 8 mm de diamètre en agate; on ajoute 30 ml d'éthanol; on recouvre avec un couvercle en agate comme indiqué sur la Figure 34; on effectue alors le "ball-milling" pendant 3 heures à 250 tours par minute comme indiqué sur la figure. On met ensuite la poudre ainsi mélangée dans l'éthanol dans un bécher et on sèche la poudre en la chauffant à 110°C pendant 8 heures à l'air.

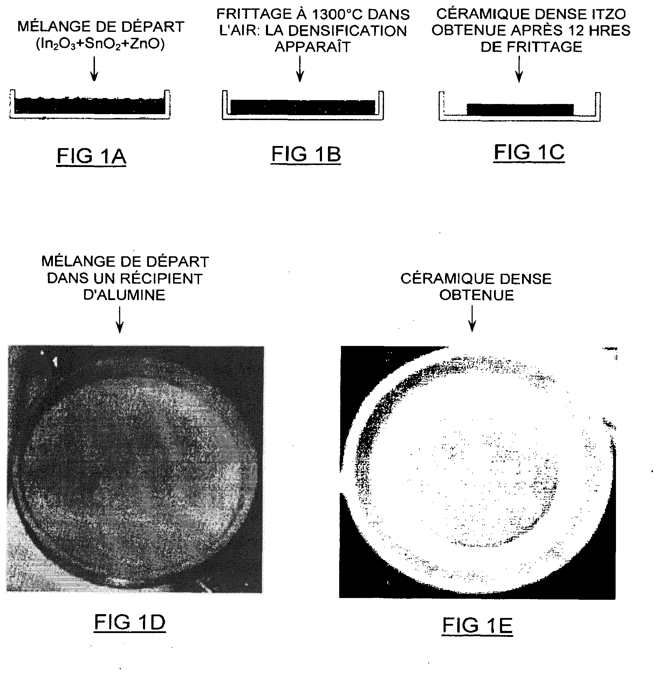

Dans l'étape 2) on dispose ensuite la poudre, en pressant à la main avec un cylindre en inox de 3 cm de diamètre, dans un récipient à fond plat en alumine de 75 mm de diamètre (Figure 1D).

Dans l'étape 3) on chauffe le récipient à raison de 300°C par heure dans le four à moufle, présenté sur l'image à gauche, jusqu'à atteindre la température de 1300°C que l'on maintient pendant 12 heures; on refroidit ensuite à raison de 300°C par heure. On obtient alors la céramique désirée (Figure 1E), utilisable pour la pulvérisation cathodique.

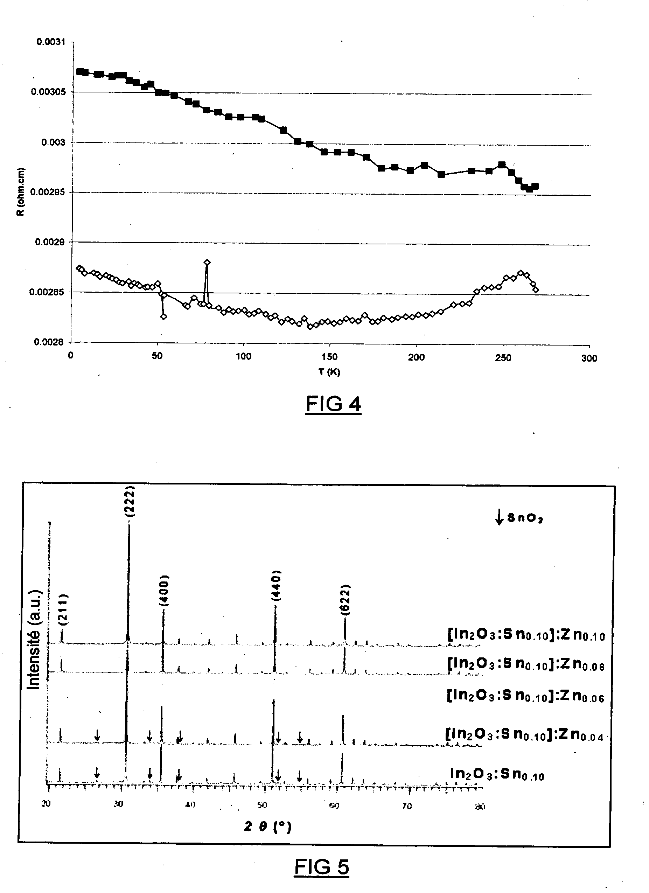

La densité des céramiques obtenues dans l'étape 3, mesurée avec un porosimètre à mercure (AutoPore IV 9500), est 91 % de la densité théorique. Leur résistivité électrique avantageusement très faible, inférieure à celle des céramiques de ITO est illustrée sur la Figure 4.

Ces caractéristiques particulièrement intéressantes confirment que les céramiques ITZO de la présente invention peuvent être avantageusement utilisées industriellement en pulvérisation cathodique DC.

Exemple 2 - Cibles pour la préparation d'électrodes pour dispositifs électrochimiques (micro-générateurs, dispositifs électrochromes).

Selon un deuxième mode préférentiel de réalisation, lorsque le matériau inorganique de base est l'oxyde $Li_4Ti_5O_{12}$, pour lequel le titane est au degré moyen d'oxydation +4, le dopant peut avantageusement être l'oxyde de zinc ZnO ou l'oxyde de magnésium MgO ou un oxyde de métal de transition tel que NiO ou $Ni_2O_3$, pour lesquels le degré d'oxydation du zinc ou du magnésium est +2, celui du nickel +2 ou +3, c'est-à-dire inférieur à celui +4 du titane. Même lorsque le rapport molaire du dopant par rapport à celui de l'oxyde d'indium est aussi faible que 0,06, des céramiques suffisamment denses pour pouvoir être utilisées en tant que cible ou élément de cible pour pulvérisation cathodique, sont obtenues par simple chauffage (pouvant être à l'air) à des températures supérieures à 1100°C (idéalement 1300°C), suivant la méthode précitée. On peut obtenir ainsi par pulvérisation cathodique RF de ces cibles des films avantageusement utilisables en tant qu'électrodes pour microgénérateurs (batteries au lithium) ou pour dispositifs électrochromes.

Exemple 2' - titane à base de $Li_4Ti_5O_{12}$ dopé avec Zn pour la préparation d'électrodes pour micro-générateurs et pour dispositifs électrochromes

Le protocole expérimental utilisé pour ITZO est utilisé à la différence que les produits de départ sont le carbonate de lithium, le dioxyde de titane, le monoxyde de zinc ou de magnésium.

Ainsi, pour préparer les cibles à base de $Li_4Ti_5O_{12}$ dopé Zn, dans l'exemple les cibles circulaires de 5 cm de diamètre et de composition $Li_4Ti_{4,70}Zn_{0,30}O_{11,7}$, et d'un poids égal à 50 grammes, on procède selon trois étapes successives selon le protocole expérimental ci-après détaillé.

Dans l'étape 1) on mélange 16,07 grammes de $Li_2CO_3$ (correspondant à 6,50 grammes de $Li_2O$), 40,85 grammes de $TiO_2$ et 2,65 grammes de ZnO en utilisant la technique bien connue dite de "ball-milling"; à cette fin, on met le mélange précité de poudre dans une des deux jattes en agate de la Figure 34 contenant chacune 50 boules de 8 mm de diamètre en agate; on ajoute 30 ml d'éthanol; on recouvre avec un couvercle en agate comme indiqué sur la Figure 34; on effectue alors le "ball-milling" pendant 3 heures à 250 tours par minute. On met ensuite la poudre ainsi mélangée dans l'éthanol dans un bécher et on sèche la poudre en la chauffant à 110°C pendant 8 heures à l'air.

Dans l'étape 2) on dispose ensuite la poudre, en pressant à la main avec un cylindre en inox de 3 cm de diamètre, dans un récipient à fond plat en alumine de 75 mm de diamètre.

Dans l'étape 3) on chauffe le récipient à raison de 300°C par heure dans le four à moufle, présenté sur l'image à gauche, jusqu'à atteindre la température de 1300°C que l'on maintient pendant 12 heures; on refroidit ensuite à raison de 300°C par heure. On obtient alors la céramique désirée (Figure 1E), utilisable pour la pulvérisation cathodique.

La densité des céramiques obtenues dans l'étape 3, mesurée avec un porosimètre à mercure (AutoPore IV 9500), est 93 % de la densité théorique. Leur résistivité électrique est élevée, de l'ordre de $10^7$ $\Omega$.cm, confirmant le caractère isolant des céramiques. De ce fait, les céramiques devront être utilisées industriellement en pulvérisation cathodique RF.

Les tests réalisés mettent en évidence qu' un tel procédé pour la préparation d'un élément de cible du type céramique pour pulvérisation cathodique constitué d'un matériau inorganique ayant un point de fusion supérieur à 300 °C est simple, rapide et peu onéreux. Un tel procédé peut être mis en oeuvre par des personnes n'ayant pas de compétences particulières dans l'art de la céramique ou du frittage et il conduit aisément à l'obtention de cibles ou d'éléments de cible permettant notamment de réaliser facilement des cibles de grande surface.

Les industriels préparent les cibles comme ITO par hot-pressing; c'est une des raisons pour laquelle les cibles sont onéreuses. Les produits (céramiques) préparé selon l'invention sont donc moins onéreux et apparaissent également nouveaux du fait que le "frittage accéléré" par l'ajout d'éléments tels que par exemple ZnO dans ITO ou dans l'oxyde d'indium (décrits dans la divulgation) augmente sensiblement la conductivité électrique des céramiques (quand on dope avec 2 % molaire de ZnO, on augmente la conductivité de ITO céramique par deux environ); en effet, de façon surprenante, il apparaît que l'on améliore la percolation entre les grains et que l'on s'affranchit davantage des problèmes de joints de grains qui altèrent la conductivité macroscopique. Les photos MEB, des Figures 2A et 2B, montrent une céramique ITO industrielle avec les joints de grain, et la céramique ITO de l'invention, dopée au zinc.

Exemple comparatif 3 - céramique de composition $In_{1,862}Sn_{0,098}Zn_{0,04}O_3$, préparée dans des conditions expérimentales similaires utilisées dans l'exemple 1'

La céramique de composition $In_{1,862}Sn_{0,098}Zn_{0,04}O_3$ est préparée comme suit :

Étape 1) On mélange 46,7410 g de $In_2O_3$, 2,6704 g de $SnO_2$ et 0,5886 g de ZnO en utilisant la technique bien connue dite "ball-milling" (voir Figure 34); à cette fin, on met le mélange précité de poudre dans une des deux jattes en agate de la Figure 34 contenant chacune 50 boules de 8 mm de diamètre en agate; on ajoute 30 ml d'éthanol; on recouvre avec un couvercle en agate comme indiqué sur la figure; on effectue alors le "ball-milling" pendant 3 heures à 250 tours par minute comme indiqué sur la figure. On met ensuite la poudre ainsi mélangée dans l'éthanol dans un bécher et on sèche la poudre en la chauffant à 110°C pendant 8 heures à l'air.

Étape 2) On dispose ensuite la poudre, en pressant à la main avec un cylindre en inox de 3 cm de diamètre, dans un récipient à fond plat en alumine de 75 mm de diamètre (Figure 1D).

Étape 3) On chauffe le récipient à raison de 300°C par heure dans le four à moufle, présenté sur l'image à gauche, jusqu'à atteindre la température de 1300°C que l'on maintient pendant 12 heures; on refroidit ensuite à raison de 300°C par heure. On obtient ainsi la céramique de faible densité précitée, inutilisable en tant que cible pour la pulvérisation cathodique.

La céramique de composition $In_{1,862}Sn_{0,098}Zn_{0,04}O_3$ ainsi obtenue présente une densité, mesurée par la technique précitée de 2,76 g/cm³, qui représente seulement 40 % de la densité théorique ce qui est largement inférieur à la limite de 70 % qui correspond à la possibilité d'utilisation comme cible pour pulvérisation cathodique.

La conductivité de cette céramique est égale à 50 siemens par cm seulement, mesurée par la technique précitée; elle est ainsi 6 fois plus faible que celle de $In_{1,805}Sn_{0,095}Zn_{0,10}O_3$.

Exemple 4 - céramique de composition $In_{1,812}Sn_{0,080}Zn_{0,098}O_{3-\delta}$, préparée pour l'application de films déposés par pulvérisation cathodique sur des substrats en verre et PET

La céramique de composition $In_{1,812}Sn_{0,080}Zn_{0,098}O_{3-\delta}$ est préparée comme suit :

Étape 1) 50 grammes de poudres de $In_2O_3$, $SnO_2$ et ZnO en quantités adéquates, suivant la composition optimisée

de la céramique [In$_2$O$_3$:Sn$_{0,10}$]:Zn$_{0,10}$, sont mélangées en utilisant la technique bien connue dite "ball-milling"; à cette fin, on met le mélange précité de poudre dans une des deux jattes en agate contenant chacune 50 boules de 8 mm de diamètre en agate; on ajoute 30 ml d'éthanol; on recouvre avec un couvercle en agate comme indiqué sur la figure; on effectue alors le "ball-milling" pendant 3 heures à 250 tours par minute comme indiqué sur la figure 34. On met ensuite la poudre ainsi mélangée dans l'éthanol dans un bécher et on sèche la poudre en la chauffant à 110°C pendant 6 heures à l'air.

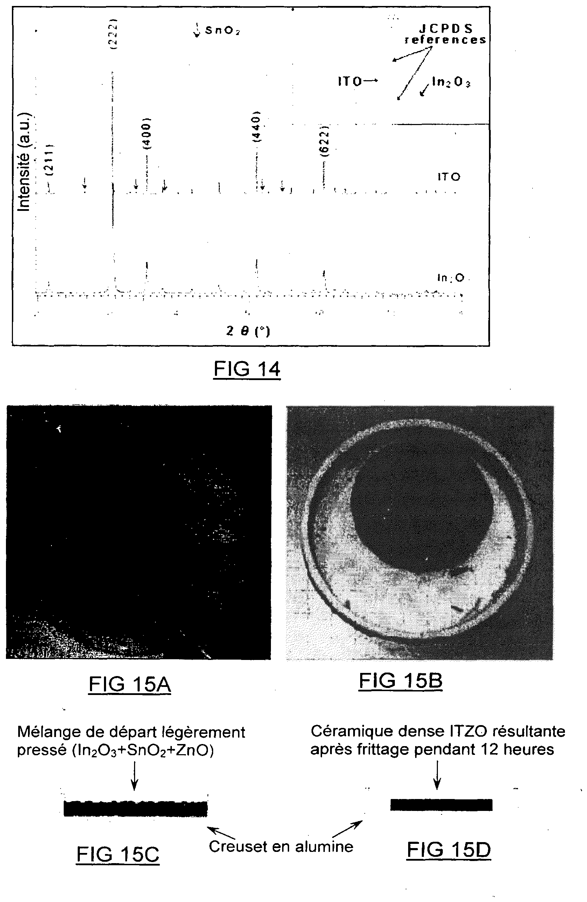

Étape 2) La poudre est pressée légèrement à la main dans un récipient à fond plat en alumine de 82,56 mm de diamètre (Figure 15A).

Étape 3) On chauffe le récipient à raison de 300°C par heure dans le four à moufle, jusqu'à atteindre la température de 1300°C que l'on maintient pendant 12 heures; on refroidit ensuite à raison de 300°C par heure. On obtient ainsi la céramique ayant une densité relative d'environ 92 %. Une céramique de diamètre final de 50 mm est obtenue après les étapes de frittage et de polissage.

Les films ITZO déposés par pulvérisation cathodique sur les substrats PET ont des performances optoélectroniques plus élevées que les films ITO de type commercial. En termes de propriétés optiques, les films ITZO ont une transparence visible élevée (supérieure à 86 % pour les films déposés sur un substrat en verre et supérieure à 80 % pour ceux déposés sur un substrat PET). La résistivité de ces films est faible (de l'ordre de $4,4 \times 10^{-4}$ $\Omega$.m pour les films déposés sur verre et de l'ordre de $4,7 \times 10^{-4}$ $\Omega$.m pour les films déposés sur PET) comparée à celles des films ITO de type commercial déposés sur ces mêmes substrats.

Caractérisation des structures

Les caractérisations réalisées montrent notamment que le co-dopage de In$_2$O$_3$ avec Sn$^{4+}$ et Zn$^{2+}$ (ITZO), forme une solution solide, permettant de préparer de nouvelles céramiques ITZO hautement denses et conductrices. Il est ainsi établi que le co-dopage notamment avec le zinc permet de préparer une cible céramique hautement dense et une large surface conductrice appropriée pour les deux types de pulvérisation cathodique DC et RF. La synthèse de telle cible a ainsi pu être réalisée avec succès par frittage direct du mélange de poudre placé dans un récipient approprié sans utiliser de procédure de pressage à froid ou à chaud (cher). Les films minces ITZO déposés sur des substrats en verre et en plastique ont ensuite été déposés à température ambiante utilisant la cible céramique avec la composition optimisée. L'influence des conditions de pulvérisation sur les propriétés optoélectroniques des films a été aussi établie.

Préparation des céramiques - Les poudres In$_2$O$_3$ (99,99 %, Aldrich), SnO$_2$ (99,9 %, Aldrich), and ZnO (99,9 %, Aldrich) ont été utilisées pour préparer des céramiques ITZO. Des quantités appropriées d'oxydes sélectionnés ont été broyées par billes pendant 30 min dans un bol en agate contenant des billes en agate et de l'éthanol. L'alcool a ensuite été évaporé à 110°C pendant 6 heures. Après séchage, la poudre a été moulue dans un mortier en agate, et remplie dans un creuset cylindrique en alumine de diamètre 16 mm et ensuite pressée à la main. La poudre mélangée, remplie dans le creuset, a été finalement frittée à 1300°C sous air pendant 12 heures. Les dimensions des granules obtenues ont été mesurées avec un pied à coulisse numérique vernier, et les granulés ont été pesés en utilisant une balance analytique, ces mesures permettant une estimation des densités apparentes des granulés.

Composition chimique et densité apparente - Selon la littérature [11, 28, 31-35], les meilleurs résultats de conductivité ont été obtenus pour une quantité de Sn$^{4+}$ qui varie de ~6-10 mol. % dans In$_2$O$_3$, dépendant des conditions de synthèse. La teneur en Sn$^{4+}$ dans les présentes céramiques a été fixée à 10 mol. %, et la teneur initiale en Zn$^{2+}$ varie dans la céramique co-dopée de 0-10 mol. %. Par souci de clarté, une identification d'échantillon simplifiée soulignant l'influence du dopage de Zn dans ITO a été adoptée (Tableau I).

Les résultats EPMA, reportés dans le Tableau I, montrent qu'il y a un bon accord entre les compositions finales de la céramique après frittage et les compositions nominales de départ. La teneur en Zn dans la composition finale de la céramique ayant la composition nominale In$_2$O$_3$:Zn$_{0,02}$ (IZO) atteint ~1,4 mol. %. Il faut noter que cette valeur est cohérente avec la limite de solubilité reportée de ZnO dans In$_2$O$_3$ (~1-2 mol. %) [24, 36]. Une légère perte de SnO$_2$ variant de ~0,5-1 mol. % (qui correspond à ~0,27 à 0,54 % massique) est aussi observée pour les deux céramiques ITZO et ITO (Tableau I).

Le tableau I présente : composition chimique de la céramique et densité apparente pour les céramiques (ITZO) [In$_2$O$_3$:Sn$_{0,10}$]:Zn$_y$, $0 \leq y \leq 0,10$. Les densités apparentes rapportées ont été déduites en mesurant les dimensions et les poids des granulés. Il faut noter que les granulés sont préparés par pressage à la main du mélange de poudre dans un creuset en alumine. Les données de In$_2$O$_3$:Zn ont été seulement données à titre de comparaison. $\delta/2$ indique la lacune neutre d'oxygène créée par le dopage avec Zn, la valeur de $\delta/2$ variant avec la teneur en Zn.

Tableau I

| Identification de l'échantillon | Mélange de départ | Composition de la céramique déterminée par EPMA $\pm$ 0,005 | ** |
|---|---|---|---|
| $In_2O_3:Zn_{0,02}$ | $(In_2O_3)_{0,99}+(ZnO)_{0,02}$ | $In_{1,966}Zn_{0,014}O_{2,993-\delta/2}$ | 3,03 |
| $In_2O_3:Sn_{0,10}$ (ITO) | $(In_2O_3)_{0,95}+(SnO_2)_{0,1}$ | $In_{1,910}Sn_{0,090}O_3$ | 2,52 |
| $[In_2O_3:Sn_{0,10}]:Zn_{0,04}$ | $[(In_2O_3)_{0,95}+(SnO_2)_{0,1}]_{0,98}+(ZnO)_{0,04}$ | $In_{1,866}Sn_{0,089}Zn_{0.045}O_{3-\delta/2}$ | 3,50 |
| $[In_2O_3:Sn_{0,10}]:Zn_{0,06}$ | $[(In_2O_3)_{0,95}+(SnO_2)_{0,1}]_{0,97}+(ZnO)_{0,06}$ | $In_{1,847}Sn_{0,091}Zn_{0,063}O_{3-\delta/2}$ | 3,92 |
| $[In_2O_3:Sn_{0,10}]:Zn_{0,08}$ | $[(In_2O_3)_{0,95}+(SnO_2)_{0,1}]_{0,96}+(ZnO)_{0,08}$ | $In_{1,827}Sn_{0,090}Zn_{0,083}O_{3-\delta/2}$ | 4,87 |
| $[In_2O_3:Sn_{0,10}]:Zn_{0,10}$ | $[(In_2O_3)_{0,95}+(SnO_2)_{0,1}]_{0,95}+(ZnO)_{0,10}$ | $In_{1,812}Sn_{0,090}Zn_{0,098}O_{3-\delta/2}$ | 6,57 |
| **Densité apparente $(g/cm^3)$ $\pm$ 0,05 | | | |

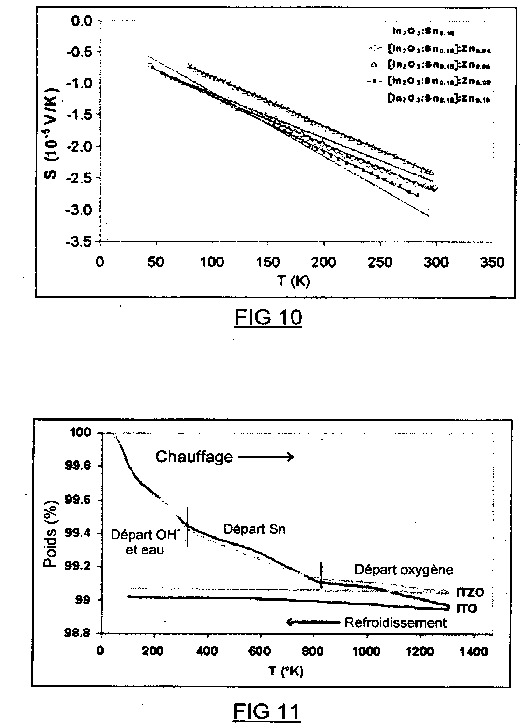

Ces résultats sont confirmés par analyse thermogravimétrique (TGA) obtenus pour les céramiques ITO et ITZO (Fig. 11). Une faible perte en poids (0,28 % massique pour $[In_2O_3:Sn_{0,10}]:Zn_{0,10}$ et 0,35 % massique pour $In_2O_3:Sn_{0,10}$) est observée entre 340°C and 800°C correspondant au départ de Sn. De plus, une perte en poids (~0,6 % massique) est observée entre la température ambiante et ~340°C qui est liée à la libération d'eau (eau adsorbée et groupes hydroxyles). Finalement, la légère perte en poids observée pour les températures plus élevées que 820°C peut être attribuée à quelque départ en oxygène. Cependant, un petit gain en poids est observé, principalement pour ITO, pendant le refroidissement des céramiques; probablement dû à une ré-oxydation partielle (Fig. 11).

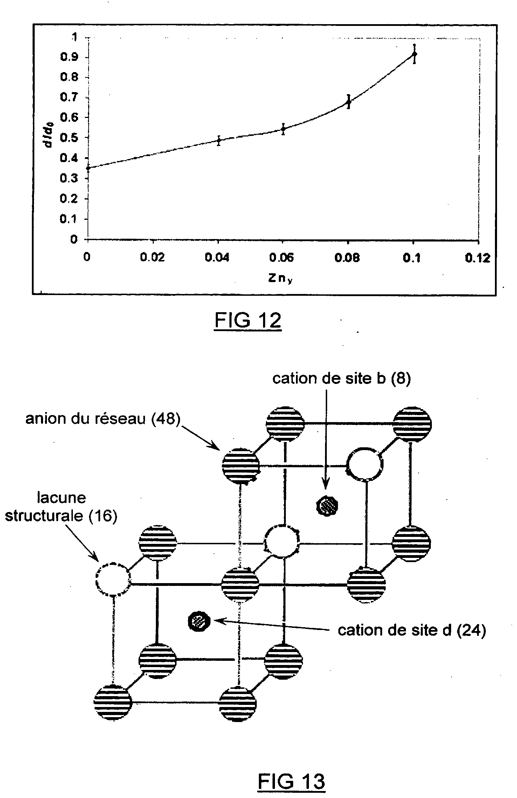

La céramique IZO ayant la composition nominale $In_2O_3:Zn_{0,02}$ (Tableau I) a une faible densité : ~3,03 $g/cm^3$; elle correspond seulement à 42 % de la densité théorique de $In_2O_3$. Cela indique que la concentration en Zn dans IZO, correspondant à la limite de solubilité de Zn dans $In_2O_3$, n'est pas suffisante pour induire une densification élevée lorsque le granulé est préparé par la méthode considérée (pressé à la main) [36]. Cependant, pour les céramiques ITZO, il s'est avéré que la densité apparente augmente de 2,52 à 6,57 $g/cm^3$ (atteignant 92 % de la densité théorique), lorsque y augmente de 4-10 mol. % [37]. D'après le Tableau I et la Fig. 12, la densité la plus élevée est observée pour la céramique co-dopée avec des quantités quasi-égales en Zn et Sn (environ 10 mol. %). L'amélioration de la densité doit être corrélée à la présence de $Zn^{2+}$ dans la position substitutionnelle (comme cela s'est produit pour les céramiques AZTO [38]), qui mène à la formation de lacunes neutres d'oxygène ($\delta/2$) selon :

$$In^{3+}_{2-x-y-\delta}Sn^{4+}_x Zn^{2+}_{y+\delta}O^{2-}_{3-(\delta/2)}\,\square_{\delta/2}\left[(x-y)e^-_{C.B.}\right] \qquad \text{(a)}$$

En effet, comme cela a été observé pour AZTO, les lacunes neutres d'oxygène promeuvent le transfert de masse au joint de grain résultant de la densification de la céramique. Cependant, la présence de $Zn^{2+}$ dans la position substitutionnelle va compenser les porteurs libres produits par le dopage avec $Sn^{4+}$ [suivant la formule (a)] résultant de la concentration en charge nette par unité de formule égale à "x-y".

Caractérisation structurale - L'oxyde d'indium a la structure cubique type bixbyite (aussi appelée structure d'oxyde de terre rare de type c) qui a une cellule unitaire de 80 atomes ($In_{32}O_{48}$) avec le groupe d'espace Ia3 et un paramètre de réseau égal à 10,117 Å [39]. Cette structure peut être dérivée de la structure apparentée à la fluorine ($CaF_2$) en enlevant un quart des anions, et en permettant de petits changements des ions [40]. Les cations indium sont localisés à deux positions sextuples non-équivalentes, référées à "b" et "d" (Fig. 13). Les cations de site b (8) sont liés par deux lacunes structurales le long de la diagonale du cube. Les cations de site d (24) sont liés par deux lacunes structurales le long de la diagonale d'une face. Il devrait être noté que ces lacunes structurales (16) sont en fait des positions interstitielles en oxygène libres.

ITO ($In_2O_3:Sn$) - Les diagrammes de diffraction de rayons X pour des poudres recuites de $In_2O_3$ et ITO (composition nominale $In_2O_3:Sn_{0,10}$) à 1300°C sont montrés sur la Fig. 14. Pour ITO, on observe quelques pics d'intensité extra-faible correspondant au $SnO_2$ rutile, en plus des pics caractéristiques de la structure type bixbyite de ITO (diagramme de référence JCPDS 89-4596). Le rapport entre le pic de ITO d'intensité la plus élevée et le pic de $SnO_2$ d'intensité la plus élevée est de 1: ~0,03. Ceci est dû à la limite de solubilité de $SnO_2$ dans $In_2O_3$ (6 mol. %) à 1300°C, comme cela a été montré par Enoki et al. [35, 36]. De plus, une diminution prononcée de la largeur à mi-hauteur des pics (FWHM full width at half maximum = largeur à mi-hauteur) pour la poudre de ITO comparée à $In_2O_3$ (diagramme

de référence JCPDS 71-2194) est observée, indiquant une amélioration de la cristallinité pour In$_2$O$_3$ dopé. Par exemple, si on considère le pic (222), qui est le pic le plus intense, il s'est avéré que la largeur à mi-hauteur diminue de 0,278 pour In$_2$O$_3$ à 0,083 pour ITO. Cette amélioration de la cristallinité semble être reliée à l'augmentation de la concentration en porteur pour In$_2$O$_3$ dopé à l'étain (Sn). Une observation similaire a aussi été précédemment reportée pour ATO. Finalement, on a noté un léger changement des principaux pics de diffraction de ITO vers des angles plus faibles comparés à In$_2$O$_3$ pur (Fig. 14), qui prend en compte une légère augmentation du paramètre de cellule unitaire de 10,117 Å pour In$_2$O$_3$ à 10,123 Å pour ITO. Ce comportement n'est pas attendu si on considère la substitution d'une partie de In$^{3+}$ par Sn$^{4+}$ parce que Sn$^{4+}$ a un rayon ionique (0,69 Å) qui est plus petit que In$^{3+}$ (0,80 Å) [41]. Ainsi, l'augmentation du paramètre de cellule pourrait être reliée à la concentration élevée en porteur électronique dans la bande de conduction et/ou à la présence de cations en positions interstitielles.

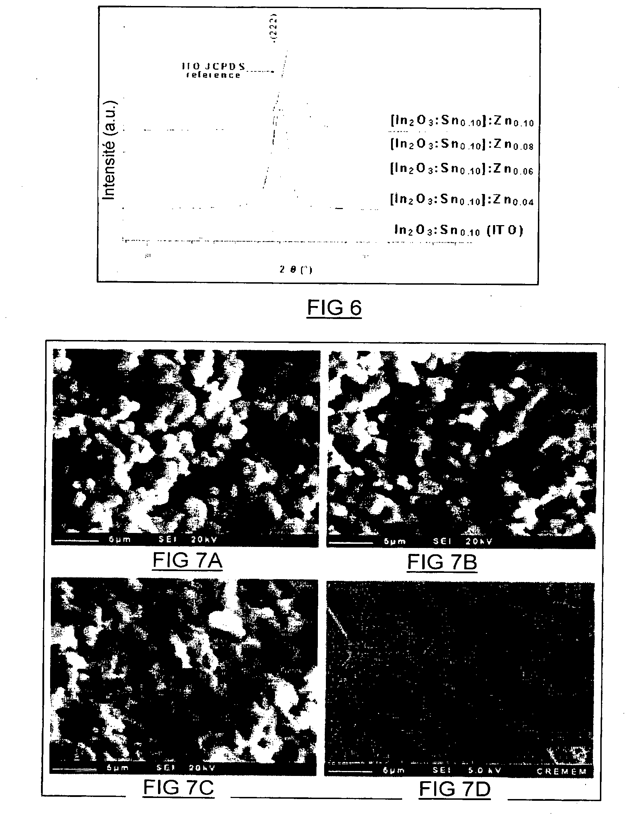

ITZO (In$_2$O$_3$:Sn:Zn) - Le diagramme de diffraction aux rayons X pour les poudres ITZO frittées (recuites d'après GDT) à 1300°C (Fig. 5) montre qu'elles sont très bien cristallisées et qu'elles adoptent la structure bixbyite de ITO. Aucun pic supplémentaire correspondant aux structures ZnO$_x$ ou Zn$_k$In$_2$O$_{3+k}$ n'est observé lorsqu'on augmente la teneur en Zn jusqu'à 10 mol. %. Néanmoins, il s'avère que les pics mineurs caractéristiques de la structure SnO$_2$ observés avec celles de la structure ITO disparaissent graduellement avec une augmentation de la teneur en Zn jusqu'à une valeur de y = 6 mol. %. Ceci confirme l'augmentation de la solubilité pour à la fois Zn et Sn lorsqu'ils sont co-dopés dans In$_2$O$_3$ [25, 36]. En effet, l'augmentation de la solubilité est attribuée à la substitution isovalente de deux In$^{3+}$ par un Zn$^{2+}$ et un Sn$^{4+}$. Une légère augmentation de FWHM (largeur à mi-hauteur) est aussi observée lors de l'augmentation de la teneur en Zn. Cette évolution est très probablement due à la diminution de la concentration de porteur avec l'augmentation de Zn (comme cela va être montré plus tard). Finalement, on a noté un déplacement des pics principaux de la diffraction vers un angle plus élevé qui augmente avec la teneur en Zn (Fig. 6), induisant une diminution du paramètre de cellule 'a' (Tableau II). Cette évolution devrait être attribuée à l'existence de Zn$^{2+}$ en positions de substitution augmentant avec la teneur en Zn comme il a déjà été suggéré dans la formule (a) ci-dessus. En fait, le Zn$^{2+}$ coordonné (six fois) a un rayon ionique (0,74 Å) qui est plus petit que celui de In$^{3+}$ (0,80 Å) [41].

Le tableau II présente l'évolution du paramètre de cellule avec la teneur en Zn pour les poudres frittées ITZO. Le paramètre de cellule ITO est ajouté comme référence.

<div align="center">

Tableau II

| Identification de l'échantillon | a (Å) |
|---|---|
| In$_2$O$_3$:Sn$_{0,10}$ (ITO) | 10,123 |
| [In$_2$O$_3$:Sn$_{0,10}$]:Zn$_{0,04}$ | 10,114 |
| [In$_2$O$_3$:Sn$_{0,10}$]:Zn$_{0,06}$ | 10,107 |
| [In$_2$O$_3$:Sn$_{0,10}$]:Zn$_{0,08}$ | 10,104 |
| [In$_2$O$_3$:Sn$_{0,10}$]:Zn$_{0,10}$ | 10,097 |

</div>

L'évolution de la morphologie de la surface de la céramique avec la teneur en Zn est présentée dans les micrographes MEB (SEM) (Fig. 7A-D). Il a été trouvé que lorsque la teneur en Zn augmente dans la céramique, la percolation de grain augmente et la porosité diminue. Ceci confirme l'augmentation graduelle de la densité avec la teneur en Zn (Voir Tableau I et Fig. 12). La densité la plus élevée (~6,57) a été observée pour la céramique qui a une teneur nominale en Zn de 10 mol. % ([In$_2$O$_3$:Sn$_{0,10}$]:Zn$_{0,10}$), qui a presque une percolation de grain complète (Fig. 7A-D). En fait le co-dopage de In$_2$O$_3$ avec Zn et Sn conduit à la présence de lacunes d'oxygène neutre (δ/2) selon :

$$In^{3+}_{1-x-y-\delta}Sn^{4+}_{x}Zn^{2+}_{y+\delta}O^{2-}_{2-(\delta/2)}\square_{\delta/2}\left[(x-y)e^{-}_{C.B.}\right] \quad (formule(a))$$

qui autorise un transfert de masse aux joints des grains et ainsi à la percolation de grain, conduisant à une augmentation de la densité de céramique [37].

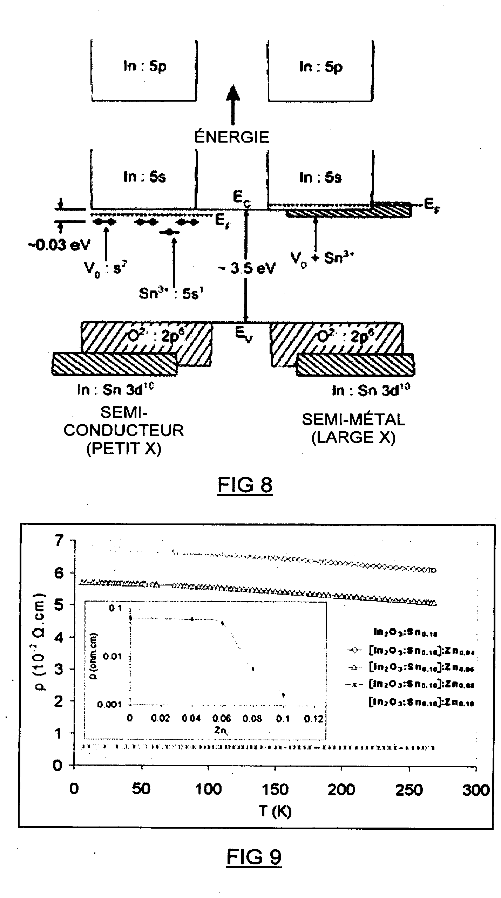

Mesures électriques - In$_2$O$_3$ est un semi-conducteur ou même un semi-métal de type n non stœchiométrique, avec une large bande d'énergie de "gap" (≈3,5 eV) semi-conducteur ou même semi-métal pour des taux de dopage élevés. L'origine d'une telle conductivité est due à la lacune en oxygène chargé (Vo) et/ou au dopage avec Sn$^{4+}$. Fan and Goodenough [11] ont développé un modèle montrant que le bas de la bande de conduction est essentiellement composé des états In:5s et le sommet de la bande de valence est composé des états O:2p (Fig. 8).

Les céramiques ITZO mettent en évidence des résistivités électriques plus faibles comparées à celle de ITO (Fig. 9). Elle diminue graduellement avec la teneur en Zn et atteint son minimum (~1,7×10$^{-3}$ Ω.cm) pour la céramique qui contient nominalement 10 mol. % de Zn. Ceci est partiellement dû à la différence de densité de céramique rapportée préalablement (Tableau I). En effet, on observe la plus faible résistivité pour une céramique qui a la densité la plus élevée. On a aussi observé un comportement semi-conducteur pour les trois céramiques ayant la résistivité la plus élevée (les résistivités les plus élevées), qui pourrait être reliée à la densité faible observée pour ces céramiques qui induisent probablement une faible mobilité. Des concentrations en porteurs de charge de la céramique ont été déduites des mesures de Seebeck qui sont réalisées à basse température (au service de "Mesure de Transport Électronique" de l'ICMCB) (Fig. 10). On a d'abord déduit la différence d'énergie entre la bande de conduction et le niveau d'énergie de Fermi entre $|E_F-E_C|$ à partir de la pente (Fig. 10) en utilisant l'équation suivante :

$$S \approx -\frac{k_B}{e}\frac{\pi^2}{|E_F - E_C|}k_B T \qquad (1)$$

dans laquelle S est le coefficient de Seebeck mesuré en V/K. La concentration de porteur de charge peut ensuite être déduite en utilisant l'équation suivante pour un semi-conducteur dégénéré :

$$E_F - E_C = \frac{h^2}{2m^*}\left(\frac{3N}{8\pi}\right)^{2/3} \qquad (2)$$

N est la concentration en porteur de charge, et m* est la masse effective de l'électron (l'hypothèse a été faite que m* est égale à $0,4\ m_e$ [42]). Toutes les données électriques déduites de Seebeck et les mesure de résistivité sont listées dans le Tableau III. Tout d'abord, la concentration de la charge diminue avec la quantité de Zn dans la céramique. Ceci peut être expliqué par l'augmentation de la substitution de $In^{3+}$ par $Zn^{2+}$ dans la structure $In_2O_3$, ce qui est confirmé par le déplacement vers angle plus élevé des différents pics des diagrammes XRD (de diffraction aux rayons X) (Fig. 6). Cependant une augmentation forte de la mobilité de la charge est observée lorsque la teneur en Zn augmente. L'augmentation de la mobilité correspond à l'augmentation importante de la percolation de grain (Fig. 7A-D) et par conséquent de la densité de céramique [36, 37]. Ainsi, une faible mobilité est obtenue pour des céramiques ayant un comportement semi-conducteur (Fig. 9) alors qu'une mobilité élevée (au moins 10 fois supérieur) est observée pour une céramique ayant un comportement métallique (Fig. 9).

Le tableau III présente les valeurs de $E_F$-$E_C$, de la mobilité, de la concentration de la charge et de la résistivité pour les céramiques ITO et différentes céramiques ITZO. La concentration de la charge a été déduite en utilisant les mesures du coefficient de Seebeck.

Tableau III

| Identification de l'échantillon | $E_F$-$E_C$ (eV) | Mobilité de la charge (cm$^2$V$^{-1}$s$^{-1}$) $\pm$ 5 % | Concentration de la charge ($\times 10^{20}$ e$^-$ cm$^{-3}$) $\pm$ 5 % | Résistivité ($10^{-3}$ $\Omega$.cm) $\pm$ 5 % |
|---|---|---|---|---|
| $In_2O_3$:$Sn_{0,10}$ (ITO) | 0,67 | 0,16 | 6,30 | 64 |
| [$In_2O_3$:$Sn_{0,10}$]:$Zn_{0,04}$ | 0,62 | 0,18 | 5,63 | 61 |
| [$In_2O_3$:$Sn_{0,10}$]:$Zn_{0,06}$ | 0,61 | 0,23 | 5,42 | 51 |
| [$In_2O_3$:$Sn_{0,10}$]:$Zn_{0,08}$ | 0,55 | 2,30 | 4,68 | 5,8 |
| [$In_2O_3$:$Sn_{0,10}$]:$Zn_{0,10}$ | 0,47 | 10,09 | 3,65 | 1,7 |

En utilisant les résultats EPMA et les mesures électriques, on peut calculer la formule finale exacte pour les céramiques ITO et ITZO. Dans le cas de la céramique ITO, on a seulement une substitution de $In^{3+}$ par $Sn^{4+}$ dans le réseau de $In_2O_3$ produisant des porteurs d'électron libre dans la bande de conduction selon la formule :

$$In^{3+}_{2-x}Sn^{4+}_{x}O^{2-}_{3}\left[xe^-_{C.B.}\right] \qquad (b)$$

x a été déduit de la concentration en porteur de charge (Tableau III) et trouvé être égale à -0,04 par unité de formule. Ainsi, on doit normalement écrire la formule suivante pour ITO :

$$\text{In}_{1,96}^{3+}\text{Sn}_{0,04}^{4+}\text{O}_3^{2-}\left[0,04\text{e}_{\text{C.B.}}^-\right] \qquad\qquad \text{(c)}$$

Cependant, la formule (c) diffère de celle déterminée en utilisant EPMA : $\text{In}_{1,91}\text{Sn}_{0,09}\text{O}_3$ qui est plus précise. En fait, rappelons que la quantité 0,09 Sn est divisée en trois parties : (i) une partie va aller former la phase additionnelle de $\text{SnO}_2$ rutile comme montré précédemment par l'analyse XRD (de diffraction aux rayons X), (ii) une autre partie substitue $\text{In}^{3+}$ en produisant des électrons libres dans la bande de conduction selon la formule (c), et (iii) les Sn restant sont très probablement ségrégués aux joints de grain lorsque le désordre de structure prédomine.

Pour ITZO, à la fois $\text{Sn}^{4+}$ et $\text{Zn}^{2+}$ substituent $\text{In}^{3+}$ dans $\text{In}_2\text{O}_3$ selon la formule (a) $\left(\text{In}_{2-x-y-\delta}^{3+}\text{Sn}_x^{4+}\text{Zn}_{y+\delta}^{2+}\text{O}_{3-(\delta/2)}^{2-}\,\square_{\delta/2}\left[(x-y)\text{e}_{\text{C.B.}}^-\right]\right).$ Les paramètres calculés (x, y, et $\delta$) et la formule finale correspondante pour les céramiques ITZO sont listés dans le Tableau IV.

Le tableau IV présente les paramètres et formule finale pour ITZO calculés en utilisant les résultats EPMA et concentration de la charge déterminée par les mesures de Seebeck.

Tableau IV

| Identification de l'échantillon | x | y | $\delta$ | Formule finale |
|---|---|---|---|---|
| $[\text{In}_2\text{O}_3{:}\text{Sn}_{0,10}]{:}\text{Zn}_{0,06}$ | 0,091 | 0,057 | 0,006 | $\text{In}_{1,847}^{3+}\text{Sn}_{0,091}^{4+}\text{Zn}_{0,063}^{2+}\text{O}_{2,997}^{2-}\,\square_{0,003}\left[(0,034)\text{e}_{\text{C.B.}}^-\right]$ |
| $[\text{In}_2\text{O}_3{:}\text{Sn}_{0,10}]{:}\text{Zn}_{0,08}$ | 0,092 | 0,062 | 0,020 | $\text{In}_{1,826}^{3+}\text{Sn}_{0,092}^{4+}\text{Zn}_{0,082}^{2+}\text{O}_{2,990}^{2-}\,\square_{0,010}\left[(0,030)\text{e}_{\text{C.B.}}^-\right]$ |
| $[\text{In}_2\text{O}_3{:}\text{Sn}_{0,10}]{:}\text{Zn}_{0,10}$ | 0,090 | 0,066 | 0,032 | $\text{In}_{1,812}^{3+}\text{Sn}_{0,090}^{4+}\text{Zn}_{0,098}^{2+}\text{O}_{2,984}^{2-}\,\square_{0,016}\left[(0,024)\text{e}_{\text{C.B.}}^-\right]$ |

Conclusions - Les granulés des céramiques ITO, IZO et ITZO ont été préparés sans utiliser de procédure de pressage à froid ou à chaud. Ils sont obtenus simplement par un mélange de poudre légèrement pressé (pressé à la main) dans un creuset cylindrique en alumine et ensuite par frittage à 1300°C. L'idée était d'être capable de préparer des cibles à grande échelle qui pourraient être utilisées pour des applications industrielles dans un procédé de déposition en phase vapeur.

Il se trouve que la composition finale de la céramique IZO a une teneur en Zn de -1,4 mol. % qui correspond à la limite de solubilité dans $\text{In}_2\text{O}_3$. La densité de la céramique IZO obtenue est faible (~3,03 g/cm³) comparée à la densité théorique de $\text{In}_2\text{O}_3$ (7,16 g/cm³). Pour la céramique ITO, un bon accord entre la composition finale de la céramique et le mélange de départ a été observé avec une toute petite perte de $\text{Sn}^{4+}$ (~1 mol. %) et sa densité est faible (35 % de la densité théorique). Pour ITZO, les compositions finales de la céramique sont aussi en bon accord avec leurs mélanges de départ avec aussi une toute petite perte de $\text{Sn}^{4+}$ (~0,5-1 mol. %). Cependant, la densité de la céramique ITZO préparée augmente graduellement lorsque la teneur en Zn augmente, due à l'augmentation des lacunes neutres en oxygène qui promeuvent le transfert de masse aux joints de grain et, de cette façon, facilite la percolation entre les grains. La densité la plus élevée (~92 % de la densité théorique) est observée pour la céramique ayant la composition nominale $[\text{In}_2\text{O}_3{:}\text{Sn}_{0,10}]{:}\text{Zn}_{0,10}$.

En bon accord avec la littérature [35], la solubilité de $\text{SnO}_2$ dans $\text{In}_2\text{O}_3$ a atteint ~6 mol. % comme cela a été montré sur les diagrammes de diffraction de rayons X. Cependant, il s'avère que la solubilité de Sn et Zn augmente lorsqu'ils co-substituent In dans $\text{In}_2\text{O}_3$. En effet, cela a été montré par l'analyse des diagrammes de diffraction de rayons X. Il n'a pas été observé de pic additionnel correspondant à des phases d'oxyde de Sn ou de Zn pour les céramiques ayant une teneur en Zn $\geq$ 6 mol. %. De plus, le petit changement des pics du diagramme de diffraction de rayons X vers des angles plus élevés prend en compte la diminution du paramètre de cellule due à la substitution de quelques $\text{In}^{3+}$ par $\text{Zn}^{2+}$.

De manière plus intéressante, les résistivités électriques des céramiques ITZO sont plus faibles que celles de leur homologue ITO dues à une densité plus élevée et à une porosité plus faible et en conséquence à une mobilité plus élevée. La résistivité la plus faible (~1,7×10⁻³ $\Omega$.cm) a été observée pour celle ayant la composition nominale $[\text{In}_2\text{O}_3{:}\text{Sn}_{0,10}]{:}\text{Zn}_{0,10}$. Pour conclure, en utilisant le simple frittage d'une poudre mélangée ITZO légèrement pressée, on a réussi à préparer une céramique hautement dense et conductrice qui convient à la pulvérisation cathodique. Rappelons que la composition nominale $[\text{In}_2\text{O}_3{:}\text{Sn}_{0,10}]{:}\text{Zn}_{0,10}$ correspond au mélange de poudres de départ :

$$[(In_2O_3)_{0,95} + (SnO_2)_{0,1}]_{0,95} + (ZnO)_{0,10}.$$

Ce mélange sera utilisé pour préparer une cible céramique qui convient au dépôt de film mince par la technique de pulvérisation cathodique.

Films minces - Les films minces ITZO ont été déposés en utilisant la technique de dépôt par pulvérisation cathodique RF. L'appareil de pulvérisation (Leybold L560) qui a été précédemment utilisé pour le dépôt des films minces ATO et AZTO a été utilisé. Ce travail a été fait en collaboration avec J. P. MANAUD, du "Centre de Ressources Couches Minces de l'ICMCB".

Préparation de la cible - Une cible céramique ITZO de diamètre de 50 mm a été préparée en utilisant la composition de céramique optimisée. Un lot de 50 g de quantités appropriées de poudres de $In_2O_3$, $SnO_2$ et ZnO ont été broyées par billes pendant 3 heures dans un bol en agate contenant des billes en agate et de l'éthanol. Puis, après évaporation de l'éthanol, la poudre a été moulue dans un mortier en agate, et ensuite remplie dans un creuset cylindrique en alumine de diamètre de 82,56 mm (voir Fig. 15A-D).

Le mélange de poudre dans le creuset a été légèrement pressé (à la main) et ensuite fritté à 1300°C sous air pendant 12 heures. La cible céramique ITZO ayant une densité relative de ~0,92 a été ensuite obtenue. Il s'est avéré que le diamètre de la cible est de ~52,5 mm après traitement thermique qui correspond à ~36,4 % de retrait dans le diamètre dû au procédé de densification. La cible de diamètre final 50 mm a été obtenue après polissage.

Paramètres optimisés de pulvérisation - En utilisant la cible déjà préparée, les films minces ITZO ont été déposés par pulvérisation cathodique magnétron RF dans une chambre de pulvérisation munie d'une turbopompe (Leybold L560). Avant le dépôt des films, la pression de gaz résiduels était d'environ $5\text{-}9 \times 10^{-5}$ Pa. Avant chaque procédé de dépôt, une pré-pulvérisation a été faite systématiquement pendant 20 min dans le but de nettoyer la surface de la cible. Le dépôt des films a été fait à température ambiante sans chauffage du substrat. Ils ont été déposés sur des substrats en verre ou en PET (polyéthylène téréphtalate), pendant divers temps de dépôt. On a fait varier la densité de puissance RF de dépôt de 0,5 to 2,5 $W/cm^2$. Cela a été fait à une pression de gaz totale fixée à 1 Pa sous un mélange d'argon (99,999 %) et d'oxygène (99,99 %), avec une pression partielle en oxygène variant entre 0 et 2 %.

Dans le but d'avoir des films avec de bonnes propriétés optoélectroniques, on a d'abord optimisé les conditions de pulvérisation. De là, on a étudié l'influence de la densité de puissance (P) et la pression partielle en oxygène ($p_{o2}$) sur la vitesse de dépôt, sur les propriétés optiques et électriques des films minces ITZO [43]. Afin d'avoir des particules pulvérisées de faible énergie (qui conviennent à un substrat en PET), la distance de la cible au substrat ($d_{t\text{-}s}$) a été fixée à 7 cm, qui est la distance maximale permettant de maintenir le plasma dans la chambre de pulvérisation à faible densité de puissance de pulvérisation de 0,5 $W/cm^2$.

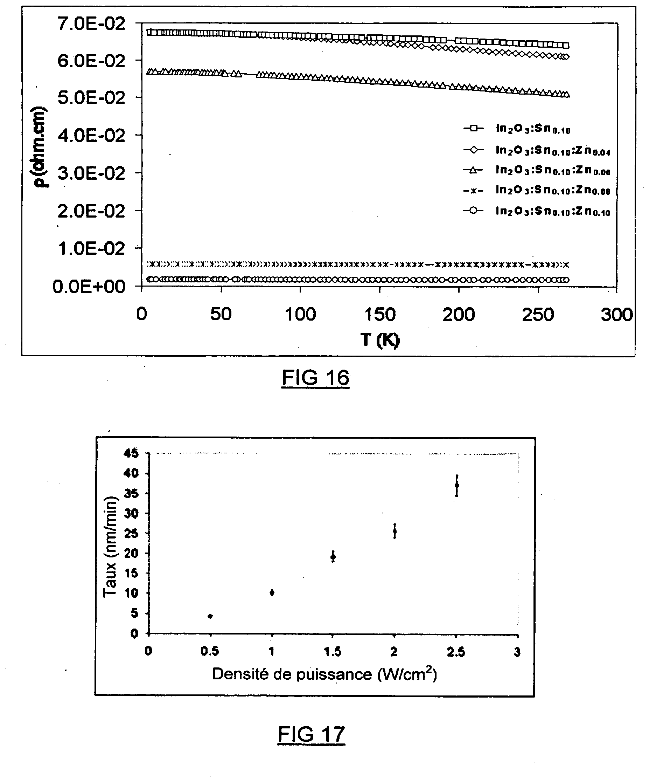

Influence des paramètres de pulvérisation sur la vitesse de dépôt - La détermination de la vitesse de dépôt a été faite, comme d'habitude, en déposant un film pour une certaine période de temps sur le substrat en verre et ensuite en mesurant l'épaisseur du film en utilisant un profilomètre. D'après la Fig. 17, le fait d'augmenter la densité de puissance de 0,5 à 2,5 $W/cm^2$ de manière presque linéaire augmente la vitesse de dépôt de 4,3 à 37,2 nm/min. En effet, une densité de puissance plus élevée induit une densité de plasma plus élevée et le transfert de moment vers la cible. Cependant, on choisit de ne pas excéder des densités de puissance plus élevées parce que l'objectif principal de cette étude est de déposer des films ITZO sur des substrats en plastique.

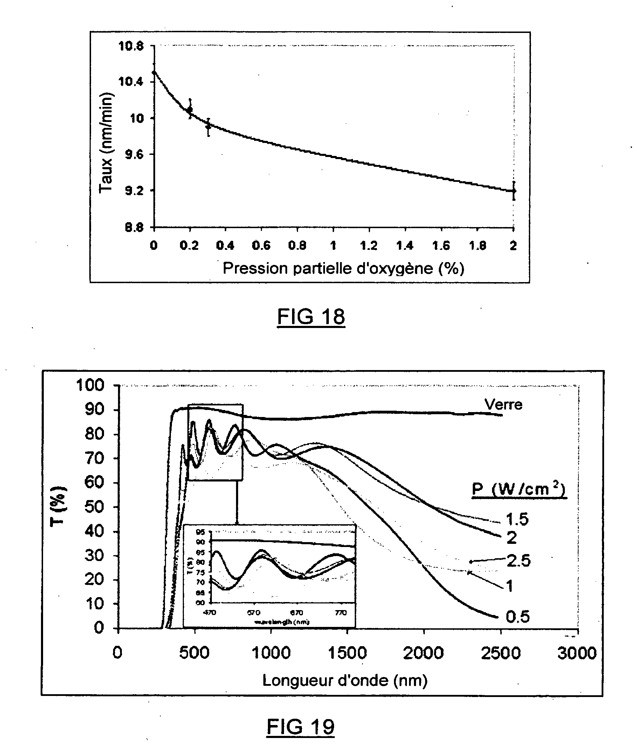

Comme prévu, contrairement à la densité de puissance, la vitesse de dépôt diminue avec une augmentation de la quantité en oxygène dans le plasma (Fig. 18). Cela peut être relié soit à la nature des ions moléculaires présents dans le plasma mélangé qui ont un libre parcours moyen plus faible induisant une probabilité plus faible pour les particules d'atteindre le substrat, soit à la composition de l'extrême surface de la cible qui varie suivant la nature du plasma et peut influencer la vitesse de dépôt.

Influence des paramètres de pulvérisation sur les propriétés optiques - La Fig. 19 montre l'évolution de la transmittance entre 200 et 2500 nm comme une fonction de la densité de puissance. La transparence visible la plus élevée (~86 %) est obtenue pour des films minces déposés sur un substrat en verre à une densité de puissance de 0,5 $W/cm^2$. Cependant, la transparence la plus faible (~71 %) est observée pour les échantillons déposés à la densité de puissance de pulvérisation la plus élevée (2,5 $W/cm^2$). En effet, à une densité de puissance élevée, il se peut qu'un phénomène de pulvérisation inverse ("back sputtering") ait lieu, causant des défauts structuraux dans le film, ce dernier introduisant des états d'énergie de sous-bandes de trous menant à une diminution de la transparence du film.

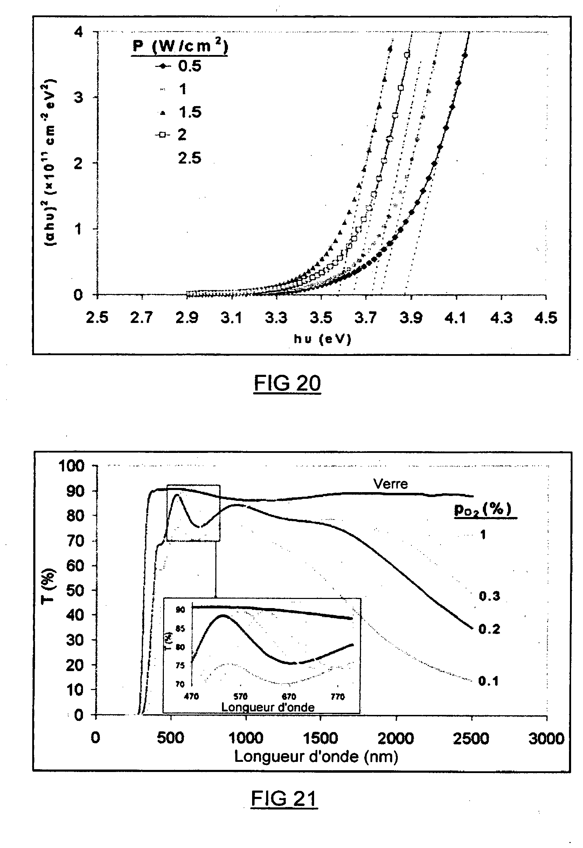

L'énergie optique de la bande interdité ($E_g$) a été déterminée en extrapolant la portion linéaire des courbes tracées (Fig. 20) à une absorption nulle. $E_g$ des films ITZO déposés diminue tout d'abord de ~3,88 à ~3.57 eV lorsque la densité de puissance augmente de 0,5 à 1,5 $W/cm^2$ (Fig. 20). Pour des densités de puissance plus grandes que 1,5 $W/cm^2$, on observe une augmentation de $E_g$. Cette dernière évolution est liée à l'évolution de la concentration de porteur (effet de Burstein-Moss [44, 45]), comme cela sera montré ci-après.

L'influence de la pression partielle en oxygène ($p_{O2}$) sur la transmission a été étudiée pour des films minces préparés sous la densité de puissance la plus faible (0,5 $W/cm^2$) qui donnent la meilleure transparence dans le domaine du visible. Une transparence visible faible (~77 %) a été observée pour le film déposé à $p_{O2}$ = 0,1 % (encart de la Fig.

21), de couleur marron. Cependant, pour des films déposés à une pression partielle en oxygène $p_{O2}$ plus grande que 0,1 %, une transparence élevée est obtenue, allant de ~88,5 à ~89,5 % pour une pression partielle en oxygène comprise entre 0,2 et 1 % et les films sont presque incolores.

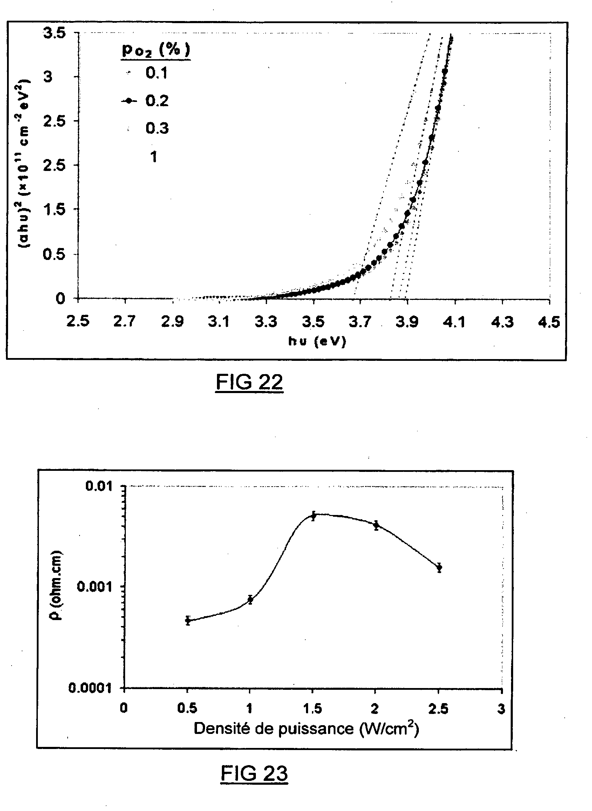

$E_g$ diminue d'environ ~3,89 à ~3,66 eV lorsque la pression partielle en oxygène dans la chambre de pulvérisation évolue de 0,1 à 1 % (Fig. 22). L'augmentation de la pression partielle en oxygène favorise la diminution des lacunes en oxygène ($\delta$) menant à une diminution de la concentration de porteur [comme cela sera vu plus tard dans la formule (d)].

Influence des paramètres de pulvérisation sur les propriétés électriques - Le Tableau V indique l'évolution de la concentration de porteur, la mobilité et la résistivité comme une fonction de la densité de puissance. La résistivité des films minces ITZO augmente de manière graduelle, de ~4,6×10⁻⁴ Ω.cm à ~5,1×10⁻³ Ω.cm, lorsque la densité de puissance augmente de 0,5W/cm² à 1,5 W/cm² (Fig. 23) et ensuite diminue pour une densité de puissance plus élevée. En effet, la résistivité est inversement proportionnelle à la concentration de porteur. Cependant, comme attendu, l'évolution de la mobilité montre une tendance inverse à la concentration de porteur même si la mobilité a une contribution mineure à la résistivité. Il faut noter que la résistivité la plus faible est obtenue pour une densité de puissance de 0,5 W/cm².

Le tableau V présente : Concentration de porteur (déterminée à partir des mesures Hall), mobilité, et résistivité pour différents films minces ITZO déposés à différentes densités de puissance.

Tableau V

| Densité de puissance (W/cm²) | Concentration de porteur (×10²⁰ e⁻ cm⁻³) ± 5 % | Mobilité cm²/V.s) ± 5% ± | Résistivité (×10⁻³ Ω.cm) ± 5 % |
|---|---|---|---|
| 0,5 | 5,54 | 24,1 | 0,46 |
| 1 | 2,82 | 29,1 | 0,76 |
| 1,5 | 0,331 | 36,8 | 5,1 |
| 2 | 0,67 | 21,6 | 4,2 |
| 2,5 | 2,11 | 18,7 | 1,6 |

L'évolution de la résistivité a été suivie comme une fonction de la pression partielle en oxygène pour les films minces ITZO déposés à une densité de puissance de 0,5 W/cm².

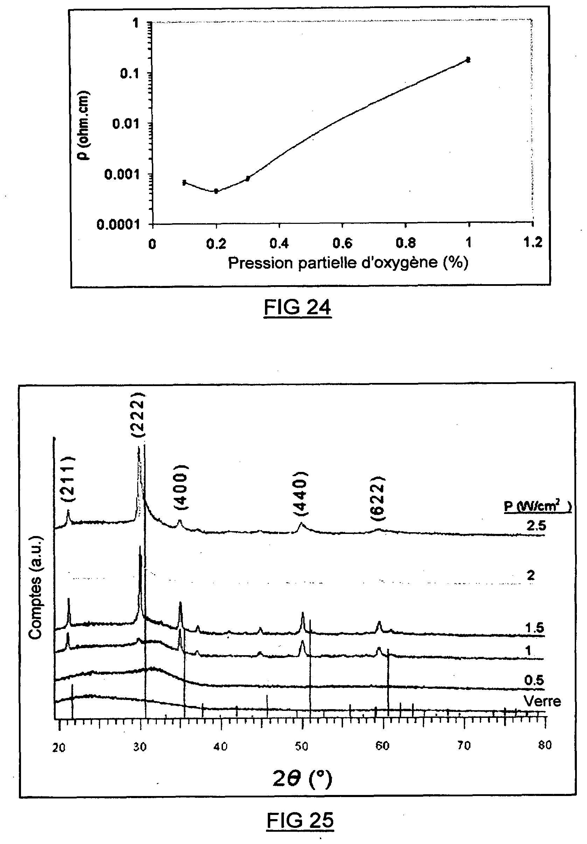

Les valeurs de la concentration de porteur, de la mobilité et de la résistivité pour différentes pressions partielles en oxygène sont consignées dans le Tableau VI. La résistivité la plus faible (~4,4×10⁻⁴ Ω.cm) est obtenue pour les films déposés à $p_{O2}$ = 0,2 % (Fig. 24). Pour des films déposés à $p_{O2}$ plus faible (0,1 %), la concentration de porteur correspond à la valeur la plus élevée (Tableau VI) qui explique la faible transparence (Fig. 21) et la $E_g$ la plus élevée (Fig. 22). Néanmoins, la mobilité est plus faible que celle des films déposés à $p_{O2}$ = 0,2 % (Tableau VIII), qui explique la résistivité plus élevée. Pour des films déposés à $p_{O2}$ plus grande que 0,2 %, la concentration de porteur diminue avec $p_{O2}$. De plus, la mobilité diminue aussi avec $p_{O2}$, qui peut être due à un désordre structural induit par l'insertion d'oxygène dans la structure amorphe qui sera mise en évidence ci-après. Par conséquent, la résistivité du film augmente radicalement (~1,7×10⁻¹ Ω.cm) lorsqu'il est déposé à $p_{O2}$ élevée (1 %).

Le tableau VI présente : Concentration de porteur déterminée par la mesure Hall, mobilité calculée, et résistivité mesurée pour différents films minces ITZO déposés à différentes pressions partielles en oxygène.

Tableau VI

| Pression partielle en oxygène (%) | Concentration de porteur (×10²⁰ e⁻ cm⁻³) ± 5 % | Mobilité (cm²/V.s) ± 5 % | Résistivité (Ω.cm) ± 5 % |
|---|---|---|---|
| 0,1 | 5,36 | 17,8 | 6,55×10⁻⁴ |
| 0,2 | 4,89 | 28,8 | 4,44×10⁻⁴ |
| 0,3 | 3,41 | 23,3 | 7,85×10⁻⁴ |
| 1 | 0,923 | 0,40 | 1,70×10⁻¹ |

Influence des paramètres de pulvérisation sur la structure et la morphologie - L'évolution des diffractogrammes de rayons X (Fig. 25) montre que le film déposé à 0,5 W/cm² a une structure amorphe aux rayons X, qui est attribuée aux particules de faible énergie qui arrivent à la surface du substrat. De plus, comme la densité de puissance RF augmente (1 et 1,5 W/cm²), les particules d'énergie plus élevée arrivent au substrat, et de là, conduisent à une meilleure cristallinité. Cependant, pour des densités de puissance plus grandes que 1,5 W/cm², la cristallinité du film diminue de façon graduelle avec la densité de puissance et on observe l'élargissement du pic. Le désordre associé à des densités de puissance plus élevées est probablement dû au phénomène de pulvérisation inverse ("back sputtering") qui induit des défauts structuraux dans le film déposé. Les ions $Zn^{2+}$ peuvent occuper deux types de sites (substitutionnels or interstitiels) dans la structure, comme indiqué dans la formule suivante :

$$In^{3+}_{2-x-y-\delta}Sn^{4+}_{x}Zn^{2+}_{y+\delta}Zn^{2+}_{z}O^{2-}_{3-(\delta/2)}\square_{\delta/2}\left[(x-y+2z)e^{-}_{C.B.}\right] \qquad (d)$$

Pour avoir une concentration de porteur élevée, il est mieux d'avoir préférentiellement $Zn^{2+}$ en position interstitiel (z).

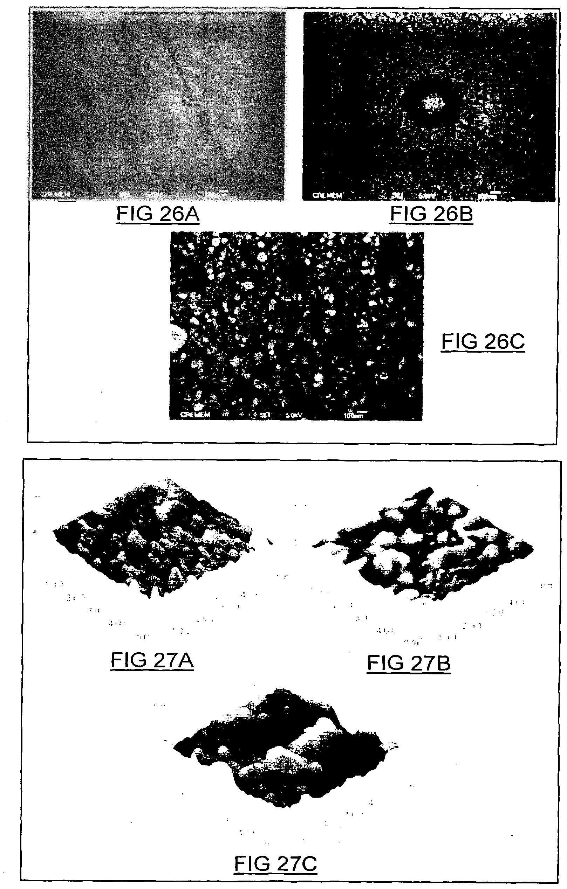

Dans une structure cristallisée, $Zn^{2+}$ occupera préférentiellement la position substitutionnelle dans le but de minimiser l'énergie et de réduire les effets stériques pendant que la création d'interstitiels ("interstitials") sera favorisée dans le cas de structure désordonnée (amorphe). De plus, Park et al. [24] ont montré que l'existence de Zn en position interstitielle dans la structure de $In_2O_3$ conduit à une augmentation du paramètre de cellule. Si on compare les positions des pics des films minces obtenus avec celles caractéristiques de ITO, on observe toujours un changement vers les angles plus faibles, qui indique une augmentation du paramètre de cellule. Ce changement est minimisé dans le cas du meilleur composé cristallisé (correspondant à la puissance de 1,5 $W/cm^2$). Ainsi, on peut s'attendre à avoir une proportion plus élevée d'interstitiels ("interstitials") dans la structure désordonnée, résultant d'une concentration de porteur plus élevée. Les photographies MEB (microscope électronique à balayage) préparées à différentes densités de puissance sont présentées sur les Figs. 26A-C. Le film déposé à densité de puissance faible (0,5 $W/cm^2$) est dense et lisse [Fig. 26A]. Cependant, un changement continu de morphologie est observé de la forme de la Fig. 26A à celle de la Fig. 26C lorsqu'on augmente la densité de puissance. Sur la Fig. 26C, la présence de grains est clairement visible à la surface avec une taille de grain ~130 nm. De plus, des zones (en gris foncé), qui peuvent correspondre au phénomène de pulvérisation inverse ("back sputtering"), sont visibles.

On a aussi étudié la rugosité de la surface en utilisant la technique de microscopie à force atomique (ou AFM atomic force microscopy) (Figs. 27A-C). Le film ITZO déposé à 0,5 $W/cm^2$ a révélé une surface très lisse qui est en bon accord avec les résultats de MEB. Cependant, la rugosité de la surface est améliorée avec la densité de puissance due à la cristallisation du film. En fait, pour des puissances de déposition plus élevées, on a trouvé une augmentation prononcée dans le $R_a$ due au phénomène de pulvérisation inverse ("back sputtering") (Tableau VII).

Le tableau VII présente : Évolution de la rugosité de surface moyenne avec la densité de puissance.

Tableau VII

| Densité de puissance ($W/cm^2$) | $R_a$ (nm) |
|---|---|
| 0,5 | 0,24 |
| 1,5 | 0,87 |
| 2,5 | 3,42 |

Paramètres de pulvérisation optimisés - Les résultats précédents qui concernent l'influence des paramètres de pulvérisation sur les films minces, permettent de conclure que :

i) la résistivité la plus faible en plus de la transparence la plus élevée a été observée pour le film mince déposé à la densité de puissance (P) de 0,5 $W/cm^2$;
ii) la transparence la plus élevée a été observée pour les films déposés à $p_{O2}$ > 0.1 %; et
iii) la résistivité la plus faible a été obtenue pour les films déposés à $p_{O2}$ = 0,2 %.

De là, les conditions de pulvérisation optimisées pour les films minces ITZO conduisant à une transparence élevée et à une résistivité la plus faible sont les suivantes :
P = 0,5 $W/cm^2$, $p_{tot}$ = 1 Pa, $p_{O2}$ = 0,2 % et $d_{t-s}$ = 7 cm.

En effet, ces paramètres de pulvérisation conduisent à des films avec une structure amorphe aux rayons X où $Zn^{2+}$ occupe préférentiellement la position interstitielle, améliorant, de cette façon, la concentration de porteur [43].

Les films minces ITZO préparés suivant les conditions optimales - Les conditions de pulvérisation optimisées ont été utilisées pour déposer les films minces ITZO sur des substrats en verre (ITZO-Verre) ou en plastique (ITZO-PET). Ensuite, on a complètement étudié la composition, la structure, la rugosité, ainsi que les propriétés optiques et électriques des films minces.

Composition - Comme d'habitude, la technique EPMA (Electron Probe MicroAnalysis) a été utilisée pour déterminer la composition des films minces. La composition des films minces ITZO déposés sous conditions de pulvérisation optimisées sur des substrats en verre ou en plastique ainsi que la composition de la cible céramique pour déposition sont indiquées dans le Tableau VIII. La composition finale des films déposés sur les substrats en verre ou en plastiques est la même. Cependant, il y a quelque petite perte en Sn and Zn comparée à la composition de la cible céramique. Cette différence peut être due aux rendements de pulvérisation différents des différentes espèces présentes dans la cible [43].

La tableau VIII présente les compositions de la céramique et du film mince ITZO déterminées par la technique EPMA.

<div align="center">

Tableau VIII

| | |
|---|---|
| Identification de la céramique et du film mince | ITZO |
| Composition finale de la céramique $\pm$ 0,005 | $In_{1,821}Sn_{0,090}Zn_{0,098}O_{3-\delta}$ |
| Composition du film mince (sur verre) $\pm$ 0,005 | $In_{1,838}Sn_{0,084}Zn_{0,078}O_{3-\delta}$ |
| Composition du film mince (sur plastique) $\pm$ 0,005 | $In_{1,839}Sn_{0,082}Zn_{0,079}O_{3-\delta}$ |

</div>

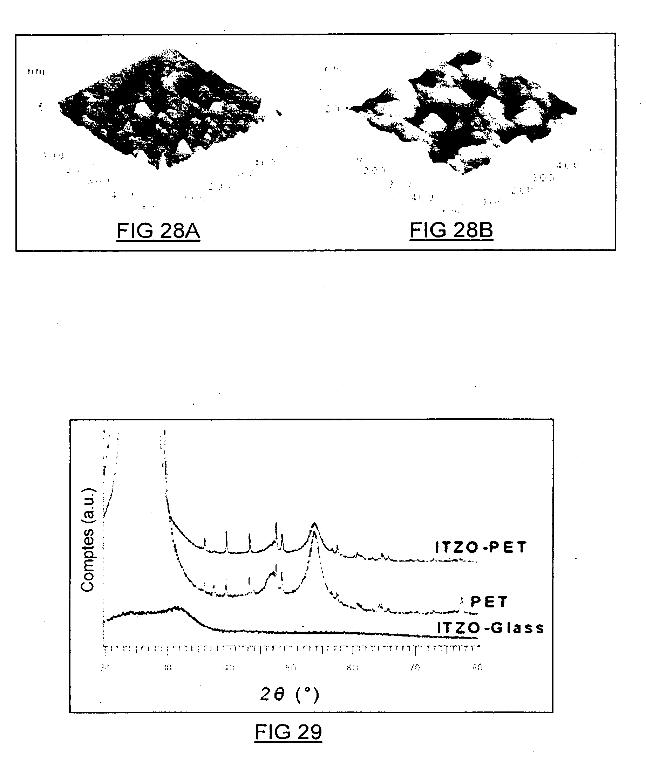

Morphologie et structure - Les Figs. 28A et 28B montrent que le film ITZO-PET a une rugosité de surface plus élevée ($R_a$ = 1,46 nm) que le film ITZO-Verre ($R_a$ = 0,24 nm). Ceci est dû à la rugosité plus élevée de la surface du substrat en plastique de départ.

Les deux films, ITZO-Verre et ITZO-PET, montrent une structure amorphe aux rayons X (Fig. 29). Comme cela a été montré précédemment, ceci est dû à la déposition du film qui a lieu à faible densité de puissance (0,5 W/cm$^2$); les pics observés sont caractéristiques du substrat en plastique (PET).

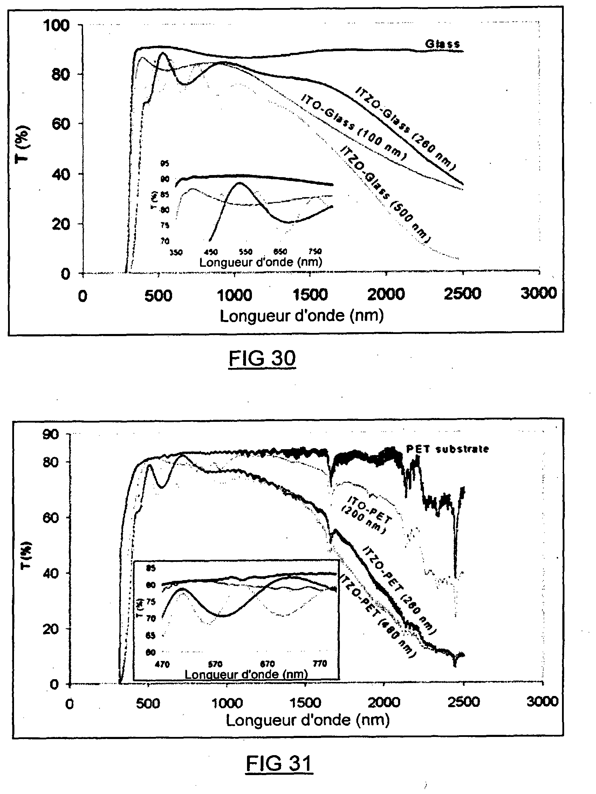

Propriétés optiques - L'évolution de la transmittance avec la longueur d'onde pour les films ITZO déposés sur des substrats en verre et en plastique est montrée respectivement sur les Figures 30 and 31.

Pour ITZO-Verre (encart de la Fig. 30), une transparence élevée (~88,5 %) est observée pour des films qui ont une épaisseur de ~260 nm, qui est proche de la valeur obtenue pour le ITO commercial déposé sur verre (ITO-Verre). Cependant, comme prévu, la transparence a à peine diminué (~3 %) lorsque l'épaisseur du film augmente jusqu'à ~500 nm. Dans le cas des films ITZO-PET (260 nm d'épaisseur) (encart de la Fig. 31), la transparence est du même ordre que celle observée pour le ITO commercial qui est déposé sur PET. Les transparences de ~82 % et de ~80 % sont obtenues pour les films ITZO-PET qui ont respectivement une épaisseur de ~260 nm et de ~480 nm. En effet, les valeurs de transparence sont considérées être très élevées en ce qui concerne la transparence du substrat en plastique (PET) (~83 %) qui limite évidemment la transparence des films.

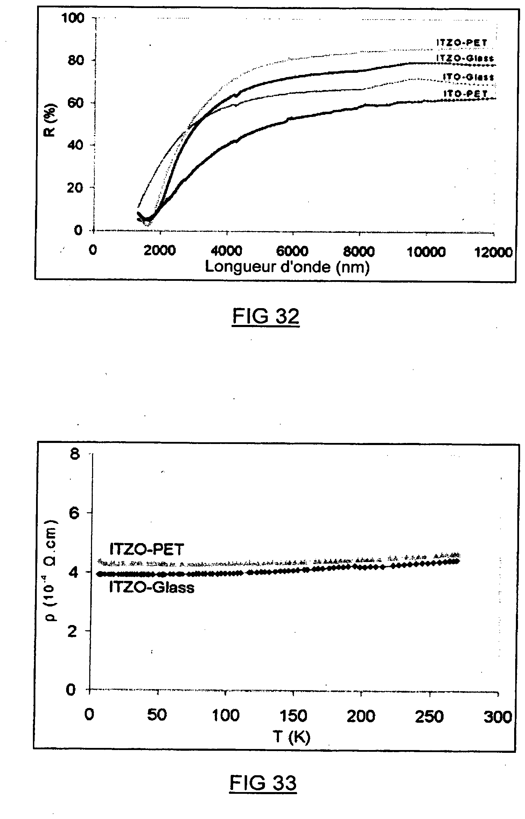

Une réflectivité IR élevée a été obtenue pour les deux films minces ITZO-Verre et ITZO-PET (Fig. 32). Elle atteint ~79 % pour les films déposés sur le verre, tandis que ~87 % est atteint pour les films déposés sur des substrats en plastique. Ceci est dû à la concentration de porteur élevée [comme ce sera montré plus bas (Tableau IX)], et de là, une fréquence de plasma plus élevée ($\omega_P$), selon $\omega_P = (Ne^2/\varepsilon_0\varepsilon_\infty m_e^*)^{1/2}$, qui induit une réflectivité IR plus élevée

suivant $R = 1 - \dfrac{2}{\omega_P \tau \varepsilon_\infty^{1/2}}$. Les films ITZO ont toujours une réflectivité plus élevée dans le domaine IR que les films ITO commerciaux à cause des valeurs élevées de la mobilité de porteur (Tableau IX).

Propriétés électriques - Bien qu'en présence d'une concentration de porteur plus élevée pour des films ITZO-PET que pour des films ITZO-Verre qui ont la même épaisseur (Tableau IX), la résistivité des films ITZO-PET est à peine plus élevée (Tableau IX et Fig. 33). La même tendance a été aussi observée pour la résistance de couche. Ce comportement est dû à la mobilité de porteur plus faible pour les films minces ITZO-PET.

Le tableau IX présente : Concentration de porteur, mobilité and résistivité pour différentes épaisseurs de ITZO-PET et de ITZO-Verre. Les données des films minces commerciaux ITO (ITO-PET et ITO-Verre) sont données à titre de comparaison.

<div align="center">

Tableau IX

| Échantillon | Épaisseur (nm) $\pm$ 20 | Concentration de porteur ($\times 10^{20}$ e$^-$ cm$^{-3}$) $\pm$ 5 % | Mobilité (cm$^2$/V.s) $\pm$ 5 % | Résistivité ($\times 10^{-4}$ $\Omega$.cm) $\pm$ 5 % | Résistance de couche ($\Omega$/□) $\pm$ 5 % |
|---|---|---|---|---|---|
| ITZO-PET | 260 | 5,30 | 25,2 | 4,68 | 18,1 |
| ITZO-PET | 480 | 5,41 | 16,2 | 5,62 | 14,0 |
| ITZO-Verre | 260 | 4,89 | 28,8 | 4,44 | 17,2 |
| ITZO-Verre | 500 | 5,04 | 26,5 | 4,67 | 9,1 |

</div>

(suite)

| Commercial | | | | | |
|---|---|---|---|---|---|
| ITO-PET | 200 | 5,00 | 10,7 | 1,17 | 58,5 |
| ITO-Verre | 100 | 8,43 | 18,6 | 3,99 | 39,9 |

Le Tableau IX montre aussi que la résistivité pour les films ITZO (260 nm) déposés sur du verre non chauffé et/ou sur des substrats en plastiques est proche de celle observée pour les films minces commerciaux ITO qui ont été déposés à ~200°C sur un substrat en verre (ITO-Verre), cette température conduisant à des films bien cristallisés. La concentration de porteur des films ITZO est plus faible que celle des films ITO-Verre, mais ils ont une mobilité plus élevée (Tableau IX). De manière plus intéressante, les films minces ITZO-PET font ressortir des résistivités plus faibles, et par conséquent des résistances de couche plus faible, que les films minces commerciaux ITO-PET qui ont été déposés de manière similaire à température ambiante. Ceci peut être expliqué par la concentration de porteur plus élevée et principalement par la mobilité de porteur plus élevée qui ont lieu dans les films ITZO-PET [43].

Conclusions - Il a été préparé, par pulvérisation cathodique magnétron RF, des films minces ITZO, déposés à partir de la cible céramique ITZO optimisée. De manière plus intéressante, les films ITZO déposés sur des substrats en polymère PET ont des performances optoélectroniques plus grandes que leurs homologues commerciaux ITO. Leur caractère amorphe permet le fait que $Zn^{2+}$ soit dans des positions interstitielles conduisant à une augmentation de la concentration de porteur, et par conséquent, de la conductivité. Dans des films ITZO cristallisés, $Zn^{2+}$ est en positions substitutionnelleconduisant à une diminution de la conductivité. Ce comportement est différent de celui observé pour ITO pour lequel la conductivité augmente lorsque la cristallinité augmente. Cette étude montre l'intérêt de tels films minces sur des substrats en plastique.

Les paramètres de pulvérisation optimisés pour avoir des performances optoélectroniques élevées sont les suivants :
$P = 0,5$ W/cm$^2$, $p_{O2} = 0,2$ %, $P_{tot} = 1$ Pa, et $d_{t-s} = 7$ cm.

Les films amorphes obtenus sur les deux substrats en verre et en plastique ont la même composition chimique et ils sont en bon accord avec la composition de la cible. On a aussi observé une légère perte en Sn et Zn dans les films due aux rendements de pulvérisation différents des différents éléments présents dans la cible. La morphologie des films minces est dense avec une surface très lisse.

En termes de propriétés optiques, les films minces ITZO ont mis en valeur une transparence visible élevée. Elle est ≥ 86 % pour ITZO-Verre et ≥ 80 % pour ITZO-PET; ces valeurs sont proches de la valeur de transmittance observée pour le film ITO commercial. Grâce à leurs mobilités de porteur élevées, la résistivité des films ITZO, déposés sur un substrat en verre ou en plastique, est aussi faible que celle observée pour ITO-Verre commercial. La valeur de résistivité la plus faible a atteint $\sim 4,4 \times 10^{-4}$ Ω.cm pour ITZO-Verre, alors qu'il a atteint $\sim 4,7 \times 10^{-4}$ Ω.cm pour ITZO-PET. De manière intéressante, les films minces ITZO ont des résistivités plus faibles, et par conséquent des résistances de couche plus faibles, que les films minces ITO-PET commerciaux, dues à la concentration de porteur plus élevée et principalement à la mobilité des porteurs plus élevée des films ITZO-PET. De plus, la réflectivité IR des films ITZO est toujours plus élevée que celle observée pour les films ITO commerciaux à cause de la mobilité de porteur plus élevée qui a lieu dans ITZO.

Puisque les films minces ITZO déposés sur des substrats en plastique (ITZO-PET) ont des performances plus élevées que leurs homologues ITO commerciaux (ITO-PET), ce sont de bons candidats pour des appareils optoélectroniques à base de polymère, tels que les ECD (ElectroChromic Devices = appareils électrochromiques) flexibles, les OLED, les cellules solaires flexibles, etc.

Avantages particuliers du procédé et des céramiques ainsi obtenues - Le procédé permet d'obtenir des céramiques de hautes densités (supérieures ou égales à 90 %, et de préférence de l'ordre de 91 %). Elles sont, de ce fait, avantageusement utilisables à l'échelle industrielle (et à fortiori en laboratoire) en tant que cible pour pulvérisation DC (cas des céramiques conductrices comme ITZO de composition $In_{1,805}Sn_{0,095}Zn_{0,10}O_3$) ou RF (cas des céramiques isolantes comme $Li_4Ti_5O_{12}$ dopé Zn de composition $Li_4Ti_{4,70}Zn_{0,30}O_{11,7}$). Le procédé présente un avantage très important en ce sens que les étapes de "pressage à chaud" (dite "Hot-Pressing") ou de pressage à température ambiante (de l'ordre de la tonne par cm$^2$) utilisées jusqu'ici pour produire les céramiques industrielles ou de laboratoire sont ici évitées. Il y a donc avec ce procédé un gain important en termes de temps de préparation (divisé au moins par un facteur 3) et donc de coût en personnel.

Il y a également avec ce procédé un gain financier important en termes de coût d'appareillage, puisqu'ici l'appareillage industriel de "Hot-Pressing", coûteux et de maintenance délicate, n'a plus lieu d'être; il en est de même de l'appareillage de pressage à température ambiante. Par ailleurs, bien que les céramiques proposées ici soient légèrement moins denses que les céramiques industrielles (ces dernières étant souvent très proches de la densité théorique, c'est-à-dire supérieures ou égales à 95 %), leur densité, de l'ordre de 90 %, voire légèrement supérieure, est amplement suffisante pour pouvoir être utilisées en tant que cibles pour pulvérisation cathodique, comme souligné plus haut.

Par ailleurs, dans le cas des céramiques conductrices de l'invention, la conductivité électrique reste avantageusement très élevée, et ce malgré une densité légèrement plus faible, également reportée.

Il a par ailleurs été démontré que la conductivité des céramiques ITZO précitées est légèrement supérieure à celles des céramiques ITO communément utilisées.

En ce qui concerne la résistivité électrique des céramiques ITZO, il a été découvert de façon surprenante que ces céramiques possèdent des résistivités électriques faibles par comparaison avec celle de ITO. Elle décroit graduellement avec la teneur en Zn et atteint son minimum pour des céramiques qui contiennent nominalement 10 moles par % de Zn. Ceci est partiellement du à la différence de la densité de la céramique. La plus faible résistivité a été observée pour la céramique ayant la densité la plus élevée. La concentration de charge diminue avec la teneur en Zn dans la céramique. Ceci peut être expliqué par l'augmentation de la substitution de $In^{3+}$ par $Zn^{2+}$ dans la structure $In_2O_3$.

En ce qui concerne la mobilité de charge, il a été découvert de façon surprenante qu'une augmentation importante de la mobilité est associée à une forte augmentation du grain de percolation. Une faible mobilité est obtenue pour des céramiques ayant un comportement semi-conducteur, alors qu'une forte mobilité est observée pour des céramiques ayant un comportement métallique.

La plus forte densité (environ 93 % de la densité théorique) est observée pour les céramiques ayant la composition nominale $[In_2O_3 :Sn_{0,10}]:Zn_{0,10}$.

De façon surprenante, les résistivités des céramiques ITZO sont plus faibles que celles de ITO, en raison d'une densité plus élevée et d'une porosité plus faible et à cause d'une plus grande mobilité.

Le diagramme de diffraction aux rayons X pour les poudres ITZO frittées (recuites d'après GDT) à 1300°C (Fig. 5) montre qu'elles sont très bien cristallisées et qu'elles adoptent la structure bixbyite de ITO. Aucun pic supplémentaire correspondant aux structures $ZnO_x$ ou $Zn_kIn_2O_{3+k}$ n'a été observé lorsque l'on augmente la teneur en Zn jusqu'à une concentration de 10 mol. %.

Références

[1] J. I. Hamberg, C. G. Granqvist, J. Appl. Phys. 60 (1986) R123.

[2] C. G. Granqvist, Appl. Phys. A 52 (1991) 83.

[3] C. G. Granqvist, A. Hultaker, Thin Solid Films 411 (2002) 1.

[4] J. M. Phillips, R. J. Cava, G. A. Thomas, S. A. Carter, J. Kwo, T. Siegrist, J. J. Krajewski, J. H. Marshall, W. F. Peck, Jr., D. H. Rapkine, Appl. Phys. Lett. 67 (1995) 2246.

[5] B. G. Lewis, D. C. Paine, MRS Bull. 25 (2000) 22.

[6] A. J. Freeman, K. R. Poeppelmeier, T. O. Mason, R. P. H. Chang, T. J. Marks, MRS Bull. 25 (2000) 45.

[7] R. Wang, L. L. H. King, A. W. Sleight, J. Mater: Res. 11 (1996) 1659.

[8] C. Ktlic, A. Zunger, Phys. Rev. Lett. 88 (2002) 95501.

[9] K. Nomura, H. Ohta, K. Ueda, T. Kamiya, M. Hirano, H. Hosono, Science 300 (2003) 1269.

[10] B. Yaglioglu, Y. Huang, Hy. Y. Yeom, D. C. Paine, Thin Solid Films 496 (2006) 89.

[11] J. C. C. Fan, J. B. Goodenough, J. Appl. Phys. 48 (1977) 3524.

[12] E. Fortunato, A. Pimentel, A. Gonçalves, A. Marques, R. Martins, Thin Solid Films 502 (2006) 104.

[13] T. Minami, T. Kakumu, Y. Takeda, S. Takata, Thin Solid Films 290-291 (1996) 1.

[14] N. Naghavi, A. Rougier, C. Marcel, C. Guéry, J. B. Leriche, J .M. Tarascon, Thin Solid Films 360 (2000) 233.

[15] N. Naghavi, C. Marcel, L. Dupont, A. Rougier, J. B. Leriche, C. Guéry, J. Mater. Chem. 10 (2000) 2315.

[16] N. Naghavi, C. Marcel, L. Dupont, C. Guéry, C. Maugy, J.M. Tarascon, Thin Solid Films 419 (2002) 160.

[17] T. Sasabayashi, N. Ito, E. Nishimura, M. Kon, P.K. Song, K. Utsumi, A. Kaijo, Y. Shigesato, Thin Solid Films 445 (2003) 219.

[18] Y. S. Jung, J. Y. Seo, D. W. Lee, D. Y. Jeon, Thin Solid Films 445 (2003) 63.

[19] N. Ito, Y. Sato, P. K. Song, A. Kaijio, K. Inoue, Y. Shigesato, Thin Solid Films 496 (2006) 99.

[20] D. Y. Ku, I. H. Kim, I. Lee,K. S. Lee, T. S. Lee, J. H. Jeong, B. Cheong, Y. J. Baik, W. M. Kim, Thin Solid Films 515 (2006) 1364.

[21] T. Minami, T. Kakumu, S. Takata, J. Vac. Sci. Technol., A 14 (3) (1996) 1704.

[22] N. Naghavi, L. Dupont, C.Marcel, C. Maugy, B. Laïk, A. Rougier, C.Guéry, J.M. Tarascon, Electrochim. Acta 46 (2001) 2007.

[23] T. Moriga, D. D. Edwards, T. O. Mason, J. Am. Ceram. Soc. 81 (1998) 1310.

[24] D. H. Park, K. Y. Son, J. H. Lee, J. J. Kim, J. S. Lee, Solid State Ionics 172 (2004) 431.

[25] G. B. Palmer, K. R. Poeppelmeier, T. O. Mason, Chem. Mater. 9 (1997) 3121.

[26] A. Ambrosini, G. B. Palmer, A. Maignan, , K. R. Poeppelmeier, M. A. Lane, P. Brazis, C. R. Kannewurf, T. Hogan, T. O. Mason, Chem. Mater. 14 (2002) 52.

[27] A. Ambrosini, S. Malo, K. R. Poeppelmeier, M. A. Lane, C. R. Kannewurf, T. O. Mason, Chem. Mater. 14 (2002) 58.

[28] T. Minami, T. Kakumu, K. Shimokawa, S. Takata, Thin Solid Films 317 (1998) 318.

[29] T. Minami, T. Yamamoto, Y. Toda, T. Miyata, Thin Solid Films 373 (2000) 189.

[30] H. M. Ali, phys. stat. sol. a 202 (2005) 2742.

[31] M. Russak, J. De Carlo, J. Vac. Sci. Technol. 1 (1983) 1563.

[32] H. Kim A. Piqué, J. S. Horwitz, H. Mattoussi, H. Murata, Z. H. Kafafi, D. B. Chrisey, Appl. Phys. Lett. 74 (1999) 3444.

[33] T. O. Mason, a G. B. Gonza lez,a J.-H. Hwangb, D. R. Kammler, Phys. Chem. Chem. Phys. 5 (2003) 2183.

[34] H. Kim, C. M. Gilmore, J. Appl. Phys. 86 (1999) 6451.

[35] H. Enoki, J. Echogoya, H. suto, J. Mater. Sci. 26 (1991) 4110.

[36] I. Saadeddin, B. Pecquenard, G. Campet," Zn and Sn doped In2O3 ceramics : structural and electrical characterization", to be published.

[37.] Canadian patent application no. 2,547,091 (priority of this application)

[38] I. Saadeddin, H. S. Hilal, B. Pecquenard , J. Marcus, A. Mansouri, C. Labrugere, M. A. Subramanian, G. Campet, Solid state Sci. 8 (2006) 7.

[39] M. Marezio, Acta Cryst. 20 (1966) 723.

[40] J. H. W. De Witt, J. Solid State Chem. 20 (1977) 143.

[41] R D. Shannon, Acta Cryst. A 32 (1976) 751.

[42] C. Marcel, Ph.D. thesis, Bordeaux 1 University, Bordeaux, France (1998).

[43] I. Saadeddin, B. Pecquenard, J. P. Manaud, G. Campet, "Synthesis and characterization of Zn and Sn doped In2O3 thin films deposited on glass and plastic PET substrates" to be published.

[44] E. Burstein, Phys. Rev. 93 (1954) 632.

[45] T. S. Moss, Proc. Phys. Soc. London Sect. B 67 (1954) 775.

Bien que la présente invention ait été décrite à l'aide de mises en œuvre spécifiques, il est entendu que plusieurs variations et modifications peuvent se greffer auxdites mises en oeuvre, et la présente invention vise à couvrir de telles modifications, usages ou adaptations de la présente invention suivant en général les principes de l'invention et incluant toute variation de la présente description qui deviendra connue ou conventionnelle dans le champ d'activité dans lequel se retrouve la présente invention;

## Revendications

1. Céramique constituée d'un matériau inorganique de base dopé par un élément J, ledit matériau inorganique de base ayant un point de fusion supérieur à 300°C, ledit dopant étant constitué par un seul matériau inorganique ou par un mélange d'au moins deux matériaux inorganiques ayant un effet dopant sur le matériau inorganique de base, ladite céramique étant représentée par la formule (I)

$$E_{\alpha-x'}{}^k J_{x'}{}^m O_{\beta-x'(k-m)/2}{}^{2-} \square_{x'(k-m)/2}$$

dans laquelle :

- $E_\alpha{}^k O_\beta{}^{2-}$ désigne le matériau inorganique de base ;
- E désigne au moins un métal des groupes I à VIII du Tableau Périodique des Eléments, et k désigne le degré d'oxydation moyen de E dans la formule I ;
- J représente au moins un métal des groupes I à VIII du Tableau Périodique, et m désigne le degré d'oxydation moyen de l'élément J qui est partiellement substitué à E, m est un nombre entier positif tel que $m < k$ ;
- $\alpha$, k et $\beta$ sont des nombres positifs compris entre 1 et 20, tels que $ak - 2\beta = 0$;
- x' désigne le taux de substitution et est un nombre positif tel que $x' < \alpha$ ;
- $\square$ représente une lacune anionique ;

ladite céramique étant **caractérisée par** une structure cristalline de type bixbyite et en ce que le matériau inorganique de base est $In_2O_3$, la céramique présentant une conductivité supérieure à 70 % de la conductivité théorique, et comportant des pourcentages molaires en $SnO_2$ et ZnO chacun compris entre 3 et 15 %, avec un pourcentage en ZnO supérieur ou égal à celui de $SnO_2$,
ladite céramique étant **caractérisée en ce qu'**elle présente au moins une des propriétés suivantes :

i) une conductivité électrique macroscopique, mesurée selon la méthode des quatres pointes (Four Probe measurements) avec un appareil Keithley (modèle 2400 Source Meter), qui est supérieure à 300 siemens par cm;

ii) une masse volumique apparente améliorée, mesurée selon la méthode du porosimètre à mercure, comprise entre 6 et 7,1 $g/cm^3$;

iii) une surface (totale) supérieure à 5 $cm^2$;

iv) un pourcentage amélioré d'irrégularités de joints de grains, mesuré selon la méthode de microscopie électronique à haute résolution qui est inférieur à 30 % de celui d'une céramique correspondante préparée sans ajout d'élément dopant par la méthode conventionnelle; et

v) une taille des pores présents dans la céramique, mesurée par la méthode du MEB à haute résolution, qui est comprise entre 0,1 et 0,8 micromètres.

2. Céramique selon la revendication 1, dans laquelle le rapport molaire matériau inorganique dopant/matériau inorganique de base varie entre 0,001 et 0,4.

3. Céramique selon l'une quelconque des revendications 1 ou 2, **caractérisée par** une très forte cristallinité qui, mesurée selon la méthode de diffraction de rayons X correspond à une taille des cristallites comprise entre 100 et 200 nm.

4. Céramique selon la revendication 1, présentant une conductivité qui, mesurée selon la méthode à quatre points, et en fonction de la température variant de 4,2 K à température ambiante, est comprise entre 200 et 10000 siemens, de préférence entre 300 et 5000 siemens, plus préférentiellement encore d'environ 580 siemens par cm.

5. Céramique selon l'une quelconque des revendications 1 à 4, présentant une mobilité de charge améliorée qui, mesurée selon la méthode de l'effet Seebeck, est comprise entre 0,01 et 300 $cm^2/vol.s^{-1}$.

6. Céramique l'une quelconque des revendications 1 à 5, **caractérisée par** une mobilité de charge supérieure à 10,1 $cm^2/vol.s^{-1}$.

7. Céramique selon la revendication 1, dans laquelle le pourcentage en ZnO est supérieur à celui de $SnO_2$.

8. Céramique selon la revendication 1 ou 7, dans laquelle le pourcentage molaire en ZnO est compris entre 6 et 10 %.

9. Céramique selon la revendication 8, obtenue à partir d'un mélange contenant 82,23 mol. % de matériau inorganique de base de formule $In_2O_3$ et 8,66 mol. % de dopant $SnO_2$ et 9,11 mol. % de dopant ZnO, ce dernier dopant (ZnO) assurant la densification, la céramique étant **caractérisée par** :

   - une conductivité électrique comprise entre 300 et 500 siemens par cm;
   - une densité comprise entre 6 et 7,1 $g/cm^3$;
   - une surface (totale) comprise entre 1 et 1000 $cm^2$; et
   - un pourcentage d'irrégularités compris entre 5 et 20 %, et de préférence inférieur à 10 %.

10. Utilisation d'une céramique telle que définie à l'une quelconque des revendications 1 à 9 comme cible pour pulvérisation cathodique RF ou DC.

11. Procédé de préparation d'un film transparent et conducteur métallique par pulvérisation cathodique d'une céramique telle que définie à l'une quelconque des revendications 1 à 9.

**Patentansprüche**

1. Keramik, bestehend aus einem anorganischen Basismaterial, dotiert mit einem Element J, wobei das anorganische Basismaterial einen Schmelzpunkt über 300 °C hat, wobei das Dotiermittel aus einem einzigen anorganischen Material oder aus einem Gemisch aus mindestens zwei anorganischen Materialien besteht, mit einer Dotierwirkung auf das anorganische Basismaterial, wobei die Keramik durch die Formel (I)

$$E_{\alpha-x}{}^k J_x{}^m O_{\beta-x'(k-m)/2}{}^{2-} \square_{x'(k-m)/2}$$

dargestellt ist, wobei:

- $E_\alpha^k O_\beta^{2-}$ das anorganische Basismaterial bezeichnet;
- E mindestens ein Metall der Gruppen I bis VIII des Periodensystems der Elemente bezeichnet und k den mittleren Oxidationsgrad von E in der Formel I bezeichnet;
- J mindestens ein Metall der Gruppen I bis VIII des Periodensystems bezeichnet und m den mittleren Oxidationsgrad des Elements J bezeichnet, das teilweise durch E ersetzt ist, wobei m eine positive Ganzzahl wie m < k ist;
- $\alpha$, k und $\beta$ positive Zahlen zwischen 1 und 20 wie $\alpha k - 2\beta = 0$ sind;
- x' den Substitutionsgrad bezeichnet und eine positive Zahl wie x' < $\alpha$ ist;
- □ eine Anionenvakanz darstellt;

wobei die Keramik durch eine kristalline Struktur vom Typ Bixbyite gekennzeichnet ist und das anorganische Basismaterial $In_2O_3$ ist, wobei die Keramik eine Leitfähigkeit über 70 % der theoretischen Leitfähigkeit aufweist und Molprozente an $SnO_2$ und ZnO jeweils zwischen 3 und 15 % aufweist mit einem Prozentsatz an ZnO, der höher oder gleich dem an $SnO_2$ ist,

wobei die Keramik **dadurch gekennzeichnet ist, dass** sie mindestens eine der folgenden Eigenschaften aufweist:

i) eine makroskopische elektrische Leitfähigkeit, gemessen gemäß der Vier-Spitzen-Methode (Four Probe Measurements) mit einem Keithley-Apparat (Modell 2400 Source Meter), die über 300 Siemens je cm ist;
ii) eine verbesserte scheinbare Dichte, gemessen gemäß der Quecksilberporosimetermethode, zwischen 6 und 7,1 $g/cm^3$;
iii) eine Oberfläche (insgesamt) über 5 $cm^2$;
iv) einen verbesserten Prozentsatz von Korngrenzenunregelmäßigkeiten, gemessen gemäß der hochauflösenden Elektromikroskopiemethode, der 30 % unter demjenigen einer entsprechenden Keramik liegt, die ohne Hinzufügung eines Dotierelements konventionell hergestellt wurde; und
v) eine Größe der in der Keramik vorhandenen Poren, gemessen gemäß der hochauflösenden MEB-Methode, die zwischen 0,1 und 0,8 Mikrometer liegt.

2. Keramik nach Anspruch 1, wobei das molare Verhältnis anorganisches Dotiermaterial/anorganischen Basismaterial zwischen 0,001 und 0,4 schwankt.

3. Keramik nach einem der Ansprüche 1 oder 2, **gekennzeichnet durch** eine sehr hohe Kristallinität, die, gemessen gemäß der Röntgenstrahldiffraktionsmethode, einer Größe der Kristallite zwischen 100 und 200 nm entspricht.

4. Keramik nach Anspruch 1, aufweisend eine Leitfähigkeit, die, gemessen gemäß der Vier-Spitzen-Methode, und in Abhängigkeit von der Temperatur, die von 4,2 K bis Raumtemperatur schwankt, zwischen 200 und 10000 Siemens, vorzugsweise zwischen 300 und 5000 Siemens, noch vorzugsweiser bei zirka 580 Siemens je cm liegt.

5. Keramik nach einem der Ansprüche 1 bis 4, aufweisend eine verbesserte Ladungsträgerbeweglichkeit, die, gemessen gemäß der Seebeckeffekt-Methode, zwischen 0,01 und 300 $cm^2/vol.s^{-1}$ liegt.

6. Keramik nach einem der Ansprüche 1 bis 5, **gekennzeichnet durch** eine Ladungsträgerbeweglichkeit über 10,1 $cm^2/vol.s^{-1}$.

7. Keramik nach Anspruch 1, wobei der Prozentsatz an ZnO höher ist als der an $SnO_2$.

8. Keramik nach Anspruch 1 oder 7, wobei der Molprozentsatz an ZnO zwischen 6 und 10 % liegt.

9. Keramik nach Anspruch 8, erhalten aus einem Gemisch, das 82,23 mol. % anorganisches Basismaterial der Formel $In_2O_3$ und 8,66 mol. % Dotiermittel $SnO_2$ und 9,11 mol. % Dotiermittel ZnO enthält, wobei dieses letzte Dotiermittel (ZnO) die Verdichtung sichert, wobei die Keramik **gekennzeichnet ist durch**:

- eine elektrische Leitfähigkeit zwischen 300 und 500 Siemens je cm;
- eine Dichte zwischen 6 und 7,1 $g/cm^3$;
- eine Oberfläche (insgesamt) zwischen 1 und 1000 $cm^2$; und
- einen Prozentsatz an Unregelmäßigkeiten zwischen 5 und 20 % und vorzugsweise unter 10 %.

10. Verwendung einer Keramik nach einem der Ansprüche 1 bis 9 als Ziel für RF- oder DC-Kathodenzerstäubung.

**11.** Verfahren zur Herstellung einer transparenten und leitenden Metallfolie durch Kathodenzerstäubung einer Keramik nach einem der Ansprüche 1 bis 9.

**Claims**

**1.** Ceramic consisting of an inorganic base material doped by an element J, said inorganic base material having a melting point above 300°C, said dopant consisting of one inorganic material or of a mixture of at least two inorganic materials having a doping effect on the inorganic base material, said ceramic being represented by formula (I)

$$E_{\alpha-x'}{}^{k}J_{x'}{}^{m}O_{\beta-x'(k-m)/2}{}^{2-}\square_{x'(k-m)/2}$$

wherein:

- $E_\alpha{}^k O_\beta{}^{2-}$ denotes the inorganic base material;
- E denotes at least one metal from groups I to VIII of the Periodic Table of the Elements, and k denotes the average degree of oxidation of E in formula I;
- J represents at least one metal from groups I to VIII of the Periodic Table, and m denotes the average degree of oxidation of the element J which is partially substituted for E, m is a positive integer such that m < k;
- $\alpha$, k and $\beta$ are positive numbers comprised between 1 and 20, such that $\alpha k - 2\beta = 0$;
- x' denotes the substitution rate and is a positive number such that x' < $\alpha$;
- $\square$ represents an anionic vacancy;

said ceramic being **characterized by** a bixbyite type crystalline structure and in that the inorganic base material is $In_2O_3$, the ceramic having a conductivity greater than 70% of the theoretical conductivity, and comprising molar percentages in $SnO_2$ and ZnO each between 3 and 15 %, with a percentage of ZnO greater than or equal to that of $SnO_2$, said ceramic being **characterized in that** it has at least one of the following properties:

(i) a macroscopic electrical conductivity, measured according to the four-point method (four-probe measurements) with a Keithley device (model 2400 Source Meter), which is greater than 300 siemens per cm;
(ii) an improved apparent density, measured according to the mercury porosimeter method, which is between 6 and 7.1 g/cm³;
(iii) a (total) surface area greater than 5 cm²;
(iv) an improved percentage of grain boundary irregularities, measured according to the high-resolution electron microscopy method, which is less than 30% of that of a corresponding ceramic prepared without addition of doping element by the conventional method; and
(v) a size of the pores present in the ceramic, measured by the high-resolution SEM method, which is between 0.1 and 0.8 micrometers.

**2.** Ceramic according to claim 1, wherein the molar ratio of dopant inorganic material / inorganic base material varies between 0.001 and 0.4.

**3.** Ceramic according to any one of claims 1 or 2, **characterized by** a very high crystallinity which, measured according to the X-ray diffraction method, corresponds to a crystallite size between 100 and 200 nm.

**4.** Ceramic according to claim 1, **characterized by** a conductivity which, measured according to the four-point method, and as a function of the temperature varying from 4.2 K to ambient temperature, is between 200 and 10000 siemens, preferably between 300 and 5000 siemens, more preferably of about 580 siemens per cm.

**5.** Ceramic according to any one of claims 1 to 4, **characterized by** a charge mobility which, measured according to the Seebeck effect method, is between 0.01 and 300 cm²/vol.s⁻¹.

**6.** Ceramic according to any one of claims 1 to 5, **characterized by** a charge mobility greater than 10.1 cm²/vol.s⁻¹.

**7.** Ceramic according to claim 1, wherein the percentage of ZnO is greater that that of $SnO_2$.

**8.** Ceramic according to claim 1 or 7, wherein the molar percentage of ZnO is between 6 and 10 %.

**9.** Ceramic according to claim 8, obtained from a mixture containing 82.23 mol.% of inorganic base material of formula $In_2O_3$, and 8.66 mol.% of $SnO_2$ dopant and 9.11 mol.% of ZnO dopant, the latter dopant (ZnO) ensuring the densification, le ceramic being **characterized by**:

- an electrical conductivity between 300 and 500 siemens per cm;
- a density between 6 and 7.1 g/cm$^3$;
- a (total) surface area between 1 and 1000 cm$^2$; and
- a percentage of irregularities between 5 and 20%, preferably lower than 10%.

**10.** Use of a ceramic as defined in any one of claims 1 to 9 as a target for RF or DC cathode sputtering.

**11.** Process for preparing a transparent and metallic conductor film by the cathode sputtering of a ceramic as defined in any one of claims 1 to 9.

EP 3 360 855 B1

MÉLANGE DE DÉPART
(In₂O₃+SnO₂+ZnO)

FIG 1A

FRITTAGE À 1300°C DANS
L'AIR: LA DENSIFICATION
APPARAÎT

FIG 1B

CÉRAMIQUE DENSE ITZO
OBTENUE APRÈS 12 HRES
DE FRITTAGE

FIG 1C

MÉLANGE DE DÉPART
DANS UN RÉCIPIENT
D'ALUMINE

FIG 1D

CÉRAMIQUE DENSE
OBTENUE

FIG 1E

**FIG 2A**

**FIG 2B**

GÉNÉRATEUR
r.f. 13,56 MHz

TABLE DE
SUBSTRAT

CHAMBRE À
VIDE

PLASMA Ar/O

CIBLE ITO À
PRESSION À
CHAUD

ÉCRAN MIS
À LA TERRE

CONDENSATEUR
DE BLOCAGE

PUISSANCE
RÉFLÉCHIE

RÉSEAU
D'ADAPTATION

PUISSANCE
AVANT

**FIG 3**

FIG 4

FIG 5

FIG 6

FIG 7A

FIG 7B

FIG 7C

FIG 7D

FIG 8

FIG 9

FIG 10

FIG 11

FIG 12

FIG 13

FIG 14

FIG 15A

FIG 15B

Mélange de départ légèrement pressé (In$_2$O$_3$+SnO$_2$+ZnO)

Céramique dense ITZO résultante après frittage pendant 12 heures

FIG 15C        Creuset en alumine        FIG 15D

FIG 16

FIG 17

FIG 18

FIG 19

FIG 20

FIG 21

FIG 22

FIG 23

FIG 24

FIG 25

FIG 26A

FIG 26B

FIG 26C

FIG 27A

FIG 27B

FIG 27C

FIG 28A                    FIG 28B

FIG 29

FIG 30

FIG 31

FIG 32

FIG 33

FIG 34

**RÉFÉRENCES CITÉES DANS LA DESCRIPTION**

**Documents brevets cités dans la description**

- WO 9312264 A
- US 5071800 A
- CA 2547091

**Littérature non-brevet citée dans la description**

- Degree of Doctor of Philosophy KING'S COLLEGE LONDON. **SHABBIR A. ; BASHAR B.** Study of Indium Tin Oxide (ITO) for Novel Optoelectronic Devices. University of London, Department of Electronic Engineering, 1998
- **A. AMBROSINI.** *Chem. Mater.,* 2002, vol. 14, 58-63
- **I. SAADEDDIN et al.** Simultaneous doping of Zn and Sb in SnO2 ceramics: enhancement of electrical conductivity. *Solid State Sciences,* 21 Octobre 2005, vol. 8, 7-13
- **DONG-HYUK PARK et al.** *Solid State Ionic,* 2004, vol. 172, 431-434
- **N. ITO et al.** *Electrical and optical properties of amorphous indium zinc oxide films,* 28 Septembre 2005
- **J. I. HAMBERG ; C. G. GRANQVIST.** *J. Appl. Phys.,* 1986, vol. 60, R123
- **C. G. GRANQVIST.** *Appl. Phys. A,* 1991, vol. 52, 83
- **C. G. GRANQVIST ; A. HULTAKER.** *Thin Solid Films,* 2002, vol. 411, 1
- **J. M. PHILLIPS ; R. J. CAVA ; G. A. THOMAS ; S. A. CARTER ; J. KWO ; T. SIEGRIST ; J. J. KRAJEWSKI ; J. H. MARSHALL ; W. F. PECK, JR. ; D. H. RAPKINE.** *Appl. Phys. Lett.,* 1995, vol. 67, 2246
- **B. G. LEWIS ; D. C. PAINE.** *MRS Bull.,* 2000, vol. 25, 22
- **A. J. FREEMAN ; K. R. POEPPELMEIER ; T. O. MASON ; R. P. H. CHANG ; T. J. MARKS.** *MRS Bull.,* 2000, vol. 25, 45
- **R. WANG ; L. L. H. KING ; A. W. SLEIGHT.** *J. Mater: Res.,* 1996, vol. 11, 1659
- **C. KTLIC ; A. ZUNGER.** *Phys. Rev. Lett.,* 2002, vol. 88, 95501
- **K. NOMURA ; H. OHTA ; K. UEDA ; T. KAMIYA ; M. HIRANO ; H. HOSONO.** *Science,* 2003, vol. 300, 1269
- **B. YAGLIOGLU ; Y. HUANG ; HY. Y. YEOM ; D. C. PAINE.** *Thin Solid Films,* 2006, vol. 496, 89
- **J. C. C. FAN ; J. B. GOODENOUGH.** *J. Appl. Phys.,* 1977, vol. 48, 3524
- **E. FORTUNATO ; A. PIMENTEL ; A. GONÇALVES ; A. MARQUES ; R. MARTINS.** *Thin Solid Films,* 2006, vol. 502, 104
- **T. MINAMI ; T. KAKUMU ; Y. TAKEDA ; S. TAKATA.** *Thin Solid Films,* 1996, vol. 290-291, 1
- **N. NAGHAVI ; A. ROUGIER ; C. MARCEL ; C. GUÉRY ; J. B. LERICHE ; J .M. TARASCON.** *Thin Solid Films,* 2000, vol. 360, 233
- **N. NAGHAVI ; C. MARCEL ; L. DUPONT ; A. ROUGIER ; J. B. LERICHE ; C. GUÉRY.** *J. Mater. Chem.,* 2000, vol. 10, 2315
- **N. NAGHAVI ; C. MARCEL ; L. DUPONT ; C. GUÉRY ; C. MAUGY ; J.M. TARASCON.** *Thin Solid Films,* 2002, vol. 419, 160
- **T. SASABAYASHI ; N. ITO ; E. NISHIMURA ; M. KON ; P.K. SONG ; K. UTSUMI ; A. KAIJO ; Y. SHIGESATO.** *Thin Solid Films,* 2003, vol. 445, 219
- **Y. S. JUNG ; J. Y. SEO ; D. W. LEE ; D. Y. JEON.** *Thin Solid Films,* 2003, vol. 445, 63
- **N. ITO ; Y. SATO ; P. K. SONG ; A. KAIJIO ; K. INOUE ; Y. SHIGESATO.** *Thin Solid Films,* 2006, vol. 496, 99
- **D. Y. KU ; I. H. KIM ; I. LEE ; K. S. LEE ; T. S. LEE ; J. H. JEONG ; B. CHEONG ; Y. J. BAIK ; W. M. KIM.** *Thin Solid Films,* 2006, vol. 515, 1364
- **T. MINAMI ; T. KAKUMU ; S. TAKATA.** *J. Vac. Sci. Technol.,* 1996, vol. A 14 (3), 1704
- **N. NAGHAVI ; L. DUPONT ; C.MARCEL ; C. MAUGY ; B. LAÏK ; A. ROUGIER ; C.GUÉRY ; J.M. TARASCON.** *Electrochim. Acta,* 2001, vol. 46, 2007
- **T. MORIGA ; D. D. EDWARDS ; T. O. MASON.** *J. Am. Ceram. Soc.,* 1998, vol. 81, 1310
- **D. H. PARK ; K. Y. SON ; J. H. LEE ; J. J. KIM ; J. S. LEE.** *Solid State Ionics,* 2004, vol. 172, 431
- **G. B. PALMER ; K. R. POEPPELMEIER ; T. O. MASON.** *Chem. Mater.,* 1997, vol. 9, 3121
- **A. AMBROSINI ; G. B. PALMER ; A. MAIGNAN ; K. R. POEPPELMEIER ; M. A. LANE ; P. BRAZIS ; C. R. KANNEWURF ; T. HOGAN ; T. O. MASON.** *Chem. Mater.,* 2002, vol. 14, 52

- A. AMBROSINI ; S. MALO ; K. R. POEPPELMEIER ; M. A. LANE ; C. R. KANNEWURF ; T. O. MASON. *Chem. Mater.,* 2002, vol. 14, 58
- T. MINAMI ; T. KAKUMU ; K. SHIMOKAWA ; S. TAKATA. *Thin Solid Films,* 1998, vol. 317, 318
- T. MINAMI ; T. YAMAMOTO ; Y. TODA ; T. MIYA-TA. *Thin Solid Films,* 2000, vol. 373, 189
- H. M. ALI. *phys. stat. sol. a,* 2005, vol. 202, 2742
- M. RUSSAK ; J. DE CARLO. *J. Vac. Sci. Technol.,* 1983, vol. 1, 1563
- H. KIM ; A. PIQUÉ ; J. S. HORWITZ ; H. MATTOUSSI ; H. MURATA ; Z. H. KAFAFI ; D. B. CHRISEY. *Appl. Phys. Lett.,* 1999, vol. 74, 3444
- T. O. MASON ; A G. B. GONZA LEZ ; A J.-H. HWANGB ; D. R. KAMMLER. *Phys. Chem. Chem. Phys.,* 2003, vol. 5, 2183
- C. M. GILMORE. *J. Appl. Phys.,* 1999, vol. 86, 6451
- H. ENOKI ; J. ECHOGOYA ; H. SUTO. *J. Mater. Sci.,* 1991, vol. 26, 4110
- I. SAADEDDIN ; B. PECQUENARD ; G. CAMPET. *Zn and Sn doped In2O3 ceramics : structural and electrical characterization*
- I. SAADEDDIN ; H. S. HILAL ; B. PECQUENARD ; J. MARCUS ; A. MANSOURI ; C. LABRUGERE ; M. A. SUBRAMANIAN ; G. CAMPET. *Solid state Sci.,* 2006, vol. 8, 7
- M. MAREZIO. *Acta Cryst.,* 1966, vol. 20, 723
- J. H. W. DE WITT. *J. Solid State Chem.,* 1977, vol. 20, 143
- R D. SHANNON. *Acta Cryst. A,* 1976, vol. 32, 751
- C. MARCEL. Ph.D. thesis. Bordeaux 1 University, 1998
- I. SAADEDDIN ; B. PECQUENARD ; J. P. MANAUD ; G. CAMPET. *Synthesis and characterization of Zn and Sn doped In2O3 thin films deposited on glass and plastic PET substrates*
- E. BURSTEIN. *Phys. Rev.,* 1954, vol. 93, 632
- T. S. MOSS. *Proc. Phys. Soc. London Sect. B,* 1954, vol. 67, 775